# EUROPÄISCHE PATENTSCHRIFT

(11) **EP 3 627 568 B1**
(45) Veröffentlichungstag und Bekanntmachung des Hinweises auf die Patenterteilung: **27.03.2024**
(21) Anmeldenummer: 18195944.6
(22) Anmeldetag: 21.09.2018
(51) Int. Cl.: H01L 31/18, G01N 21/64, G01N 21/95, G06T 7/00, H01L 21/66

(54) **VERFAHREN ZUR VERARBEITUNG VON ABBILDUNGEN VON HALBLEITERSTRUKTUREN, SOWIE ZUR PROZESSCHARAKTERISIERUNG UND PROZESSOPTIMIERUNG MITTELS SEMANTISCHER DATENKOMPRESSION**
METHOD FOR PROCESSING OF IMAGES OF SEMICONDUCTOR STRUCTURES AND FOR PROCESS CHARACTERIZATION AND PROCESS OPTIMISATION BY MEANS OF SEMANTIC DATA COMPRESSION
PROCÉDÉ DE TRAITEMENT DES IMAGES DES STRUCTURES À SEMI-CONDUCTEUR AINSI QUE DE CARACTÉRISATION DE PROCESSUS ET D'OPTIMISATION DE PROCESSUS AU MOYEN DE LA COMPRESSION DE DONNÉES SÉMANTIQUES

(43) Veröffentlichungstag der Anmeldung: 25.03.2020
(73) Patentinhaber: Fraunhofer-Gesellschaft zur Förderung der angewandten Forschung e.V., 80686 München (DE)
(72) Erfinder: Demant, Mattias, 79110 Freiburg (DE); Rein, Stefan, 79110 Freiburg (DE); Kovval, Aditya, 79110 Freiburg (DE); Greulich, Johannes, 79110 Freiburg (DE); Wöhrle, Nico, 79110 Freiburg (DE)
(74) Vertreter: 2SPL Patentanwälte PartG mbB

(56) Entgegenhaltungen:
- WO-A1-2009/121133
- DE-A1- 19 914 115
- DE-A1-102013 007 442
- US-A1- 2015 234 379
- RAMSPECK K ET AL: "Recombination current and series resistance imaging of solar cells by combined luminescence and lock-in thermography", APPLIED PHYSICS LETTERS, A I P PUBLISHING LLC, US, Bd. 90, Nr. 15, 9. April 2007 (2007-04-09) , Seiten 153502-153502, XP012094133, ISSN: 0003-6951, DOI: 10.1063/1.2721138

## Beschreibung

### Technisches Gebiet

Ausführungsbeispiele befassen sich mit Verfahren zur Verwendung in Solarzellenprozessen. Beispiele betreffen Verfahren zum Verarbeiten von unter Verwendung von bildgebenden Verfahren erzeugten Abbildungen einer Halbleiterstruktur einer Solarzelle, Verfahren zum Verbessern eines Halbleiterprozesses, Verfahren zur Bewertung ortsaufgelöster Qualitätsbilder von Halbleiterstrukturen und Verfahren zum Vorhersagen von zumindest einer Eigenschaft einer Solarzelle.

### Hintergrund

Bei der Produktion von Halbleiterwafern und Solarzellen ist es notwendig, die Qualität von Prozessschritten und verwendeten Materialien zu überwachen und Informationen über Einflüsse von Prozessschritten zu erlangen. Dies kann dazu dienen, verschiedene Parameter von Solarzellen einzuschätzen oder die Solarzelle einer bestimmten Qualitätsklasse zuzuordnen. Beispielsweise können elektrische Messungen vorgenommen werden, um Strom-Spannungsparameter der Solarzelle zu bestimmen.

Es ist auch möglich, bildgebende Messverfahren zur Vermessung von Wafern und Solarzellen einzusetzen. Messungen können jedoch aufgrund der variierenden räumlichen Verteilung und der variierenden Kombination der Bildstrukturen teils nicht miteinander verglichen werden. Weiterhin benötigen entsprechende Datensätze aufgrund einer entsprechend hohen Bildauflösung sehr große Speicherkapazitäten und es können entsprechend lange Datenverarbeitungszeiten auftreten. Ferner ist es schwierig, die Ergebnisse unterschiedlicher Messsysteme miteinander zu verknüpfen.

Aufgrund hoher Durchsatzzahlen bei der Serienproduktion von Solarzellen ist es jedoch notwendig, eine schnelle und effiziente Datenverarbeitung zum Überwachen der Produktionsprozesse bereitzustellen. Insbesondere ein manuelles Auswerten von Messergebnissen kann daher ungeeignet sein. Eine Auswertung und Sortierung mittels Algorithmen, die nach rein menschlichen Kriterien Bildstrukturen quantifizieren, ist in der Regel zeitaufwendig, fehleranfällig und häufig wenig aussagekräftig. Ebenso kann ein elektrisches Kontaktieren der einzelnen Solarzellen zu zeitaufwändig sein, um eine Qualitätskontrolle der Solarzellen in der Serienproduktion durchzuführen.

Für eine Klassifizierung von Solarzellen können in bekannter Weise Messungen von Strom-Spannung-Kennlinien aufgenommen werden. Diese Methode ist jedoch zeitaufwändig, da sie jeweils eine entsprechende Kontaktierung der einzelnen Solarzellen benötigt. Beispielsweise können ferner basierend auf rein elektrischen Messungen nur bedingt Ursachen für eine niedrige Qualität einer Solarzelle erkannt werden.

Eine Aufgabe der vorliegenden Erfindung ist es daher, Verfahren zur Verwendung in einer Solarzellenproduktion bereitzustellen, die eine effiziente Überwachung der Qualität verwendeter Halbleiterprozesse oder verwendeter Materialien und/oder eine Optimierung der verwendeten Halbleiterprozesse ermöglichen.

Veröffentlichung DE 19914115 A1 beschreibt ein Verfahren um mit Fehlern behaftete ungeeignete sowie zum Bruch neigende Wafer und Solarzellen kostengünstig und rechtzeitig aus dem Fertigungsprozeß auszuschleusen. Gelöst wird die Aufgabe mit einem Bildverarbeitungssystem, das aus einem Trainingssystem und einem Echtzeiterkennungssystem besteht. Zur Klassifizierung der Eingangsdaten werden die Algorithmen eines neuronalen Netzes verwendet.

Veröffentlichung DE 10 2013 007 442 A1 betrifft eine Materialbearbeitungsvorrichtung und ein Verfahren zur Bearbeitung von im Wesentlichen ebenen Werkstücken, mit wenigstens einem Bearbeitungsmittel, welches zumindest einen Bearbeitungslaser aufweist, dessen Laserfokus in Bearbeitungsstellung auf den Abstand zwischen dem zu bearbeitenden Werkstück und dem Bearbeitungslaser einstellbar oder eingestellt ist, mit wenigstens einem optischen Erfassungsmittel, dessen optische Achse im Wesentlichen koaxial mit dem Strahlengang des zumindest einen Bearbeitungslasers angeordnet ist, und mit einer Steuer- und/oder Regeleinrichtung zur Manipulation des Bearbeitungsmittels.

Veröffentlichung WO 2009/121 133 A1 beschriebt ein Verfahren, bei dem Lumineszenzbilder von Siliziumwafern aufgenommen werden. Diese Bilder werden dann verarbeitet, um Informationen über Auswirkungen wie Versetzungen innerhalb des Wafer-Materials zu erhalten. Die daraus resultierenden Informationen werden dann verwendet, um verschiedene Schlüsselparameter einer Solarzelle vorherzusagen, die aus dem Wafermaterial hergestellt werden, wie zum Beispiel Leerlaufspannung und Kurzschlussstrom.

Die Veröffentlichung RAMSPECK ET AL: "Recombination current and series resistance imaging of solar cells by combined luminescence and lock-in thermography" Applied Physics Letters, A I P PUBLISHING LLC, US Bd. 90, Nr. 15, 9. April 2007 (2007-04-09), ISSN: 0003-6951, DOI: 10.1063/1.2721138 beschreibt Rekombinationsstrom- und Reihenwiderstandsbildgebung an großflächigen Kristallinen-Silizium-Solarzellen unter Verwendung einer kombinierten Analyse der kamerabasierten Dark-Lock-in-Thermografie (DLIT) und der Elektrolumineszenz-Bildgebung (EL). Die Solarzellen werden von DLIT und EL unter identischen Betriebsbedingungen abgebildet. Die quantitative Analyse der DLIT-Messung erzeugt ein Bild der lokalen Heizleistung und das EL-Bild ergibt ein Bild der lokalen Zellspannung.

### Zusammenfassung

Die Aufgabe wird gelöst gemäß den unabhängigen Patentansprüchen. Weitere Vorteile der Erfindung können sich durch die in den abhängigen Patentansprüchen beschriebenen Weiterbildungen der offenbarten Verfahren und durch Ausführungsbeispiele der folgenden Beschreibung sowie der Figuren ergeben.

Entsprechend wird ein Verfahren zum Verarbeiten von unter Verwendung von bildgebenden Verfahren erzeugten Abbildungen einer Halbleiterstruktur einer Solarzelle beschrieben. Das Verfahren umfasst ein Verarbeiten der Abbildung der Halbleiterstruktur mittels eines trainierten neuronalen Netzes, um eine semantische Repräsentation der Abbildung zu erzeugen. Eine Datengröße der verfahrensgemäß erzeugten semantischen Repräsentation ist dabei geringer, als eine Datengröße der Abbildung. Ferner umfasst das Verfahren ein Speichern der semantischen Repräsentation zugeordnet zur Halbleiterstruktur. Die semantische Repräsentation stellt dabei einen Informationsträger von relevanten Informationen der Abbildung bereit, die für ein Bestimmen einer Eigenschaft oder eines Parameters der Solarzelle und/oder für eine Kristallanalyse der Halbleiterstruktur der Solarzelle verwendet werden können. Dadurch kann beispielsweise ermöglicht werden, semantische Repräsentationen zu verwenden, um Solarzellenparameter vorherzusagen oder aufgrund der Kristallanalyse Rückschlüsse auf das verwendete Material oder bei der Solarzellenproduktion durchgeführte Halbleiterprozesse zu ziehen.

Ein im Zusammenhang mit dieser Erfindung gezeigtes neuronales Netz kann beispielsweise von einem Prozessor (z.B. general purpose CPU), einem FPGA, einem Asic oder ähnlichen Rechenvorrichtungen, ausgeführt und/oder trainiert werden.

Halbleiterstrukturen von Solarzellen, deren Abbildungen verfahrensgemäß verarbeitet werden können, sind dementsprechend beispielsweise Halbleiterwafer, Solarzellenvorläufer wie z.B. nur teilweise prozessierte Halbleiterstrukturen, oder die bereits fertiggestellte Solarzelle selbst. Die betroffene Halbleiterstruktur kann entsprechend sowohl Bereiche umfassen, die aus Halbleitermaterial gebildet sind, als auch Bereiche der Solarzelle umfassen, die beispielsweise Kontaktierungsstrukturen aus elektrisch leitfähigem Material umfassen. Halbleiterstrukturen können ferner Halbleiterblöcke (bricks) umfassen, die beispielsweise in Wafer getrennt werden können.

Die verwendeten Abbildungen der Halbleiterstrukturen können mittels bildgebender Verfahren erzeugt worden sein oder vor dem Erzeugen der semantischen Repräsentation erzeugt werden. Geeignete Verfahren umfassen beispielsweise eine Verwendung von Elektrolumineszenz-Messungen, Photolumineszenz-Messungen, oder Temperaturaufnahmen. Ferner können Reflexionssignal-Messungen oder Transmissionssignal-Messungen verwendet werden, um die Abbildung der Halbleiterstruktur zu erzeugen. Die Abbildung der Halbleiterstruktur kann beispielsweise eine schwarz/weiß-Abbildung oder eine farbige Abbildung sein.

Entsprechend kann das Verfahren ein Erzeugen einer entsprechenden Abbildung mit einer der oben genannten Methoden oder geeigneten alternativen, dem Fachmann bekannten Methoden umfassen. Zum Beispiel können Abbildungen vor dem Erzeugen der semantischen Repräsentation bezüglich ihrer Bildauflösung auf eine gleiche Auflösung oder auf eine Standardauflösung reduziert werden, oder die Bildkoordinaten zum Zwecke einer einheitlichen Positionierung und Skalierung der Proben auf gleiche Koordinaten oder Standardkoordinaten im Bild korrigiert werden, um eine Vergleichbarkeit der Abbildungen und ortsspezifischer Informationen der jeweiligen Abbildungen zu erhöhen. Innerhalb des Netzwerkes können Eingabebilder in verschiedenen Teilnetzen vorverarbeitet werden und erst später mit der gleichen Auflösung kombiniert werden. Eine vorherige (vor dem Erzeugen der semantischen Repräsentation) Alinierung / Justierung der Daten auf ein einheitliches Koordinatensystem kann durchgeführt werden.

Beispielsweise kann basierend auf der Abbildung selbst eine Evaluierung einer Qualität oder von Parametern der Halbleiterstruktur nicht oder nur sehr schwierig möglich sein. Daher ist erfindungsgemäß vorgesehen, ein trainiertes neuronales Netz zu verwenden, um eine semantische Repräsentation der Abbildung zu erzeugen. Das Erzeugen der semantischen Repräsentation kann beispielsweise als Datenkomprimierung bezeichnet werden. Dabei können durch das neuronale Netz semantisch sinnvolle Parameter oder mit anderen Worten solche Parameter, die eine Bedeutung oder Aussagekraft bezüglich einer Materialqualität, einer Solarzellenqualität und/oder einer Prozessqualität haben, aus der Abbildung extrahiert werden. Im Gegensatz zu spezifischen optischen Bildinformationen der Abbildung kann die semantische Repräsentation abstrakte Merkmale der Abbildung umfassen, die Rückschlüsse auf Parameter der Halbleiterstruktur ermöglichen. Das neuronale Netz kann ein faltendes neuronales Netzwerk sein oder ein anderes neuronales Netz, z.B. ein rekurrentes neuronales Netzwerk.

Eine semantische Repräsentation kann eine Gewichtsverteilung von Gewichten einer Schicht des neuronales Netzes umfassen. Je nach Art des verwendeten neuronalen Netzes können bezüglich ihrer Tiefe verschiedene Schichten des neuronalen Netzes die semantische Repräsentation darstellen. Die verwendete Schicht kann einen Kompromiss zwischen einem Informationsgehalt der semantischen Repräsentation und einer Datengröße der semantischen Repräsentation darstellen. Beispielsweise kann eine letzte Schicht des neuronalen Netzes für die semantische Repräsentation verwendet werden oder eine Schicht, die näher an eine Ausgangsschicht des neuronalen Netzes, als an eine Eingangsschicht des neuronalen Netzes angeordnet ist. Ferner ist es möglich, dass die semantische Repräsentation auf Gewichtsverteilungen von Gewichten zweier oder mehrerer, beispielsweise zueinander benachbarter Schichten des neuronalen Netzes basiert.

Die für die semantische Repräsentation verwendete Schicht des Netzes kann eine Schicht sein, von der aus man mit einem linearen oder nicht-linearen Klassifikations- oder Regressionsverfahren eine Vorhersage eines Parameters, beispielsweise einen oder mehrere Zielwerte vorhersagen kann. Bei der semantischen Repräsentation kann es sich um Werte einer Schicht des neuronalen Netzes vor einer letzten linearen Regression des Netzes handeln.

In einem Beispiel kann eine Schicht eines neuronalen Netzes mit Encoder-Decoder-Struktur verwendet werden, die im Bereich eines Flaschenhalses des Netzes liegt, also z.B. die Schicht mit der geringsten Anzahl von Gewichtungen und damit mit der geringsten Datengröße. Dadurch kann eine besonders effiziente Datenkompression ermöglicht werden, wobei die entsprechende semantische Repräsentation bei geringer Datengröße alle relevanten Parameter der Abbildungen umfasst. Beispielsweise weist die semantische Repräsentation mehrere Vektoren auf, die jeweils einem vorherzusagenden Solarzellenparameter zugeordnet sind.

Es ist folglich möglich, dass durch das Erzeugen der semantischen Repräsentation ein komprimiertes Speichern der Informationen der Abbildung ermöglicht ist. In Beispielen weist die semantische Repräsentation eine Datengröße von höchstens 10 %, von höchstens 1 % oder von höchstens 0.1 % der Datengröße der Abbildung auf. Die Semantik (z.B. Aussagekraft der semantischen Repräsentation) ergibt sich aus der Kompression des Bildes, derart, dass sie aussagekräftig bezüglich eines oder mehrerer Qualitätsparameters innerhalb der Photovoltaik-Wertschöpfungskette ist.

Die semantische Repräsentation kann auf zumindest zwei mittels des neuronalen Netzes verarbeiteten Abbildungen der Halbleiterstruktur der Solarzelle basieren, die mittels unterschiedlicher bildgebender Verfahren erzeugt sind. Insbesondere können drei, vier oder mehrere Abbildungen zum Erzeugen einer semantischen Repräsentation verwendet werden. Dadurch kann zum Beispiel eine Vorhersagequalität eines Parameters der Halbleiterstruktur einer auf der semantischen Repräsentation basierenden Vorhersage oder Bestimmung des Parameters verbessert werden. Es ist möglich, dass die beiden verschiedenen Abbildungen jeweils korrelierte Informationen enthalten. Wenn beispielsweise verschiedene Abbildungen der Halbleiterstruktur vorhanden sind, kann mittels der semantischen Repräsentation die relevante Information zu Halbleiterstruktur noch effizienter komprimiert in einer einzigen semantischen Repräsentation gespeichert werden und es kann auf das Speichern mehrerer einzelner Abbildungen verzichtet werden. Im Fall von korrelierten Informationen kann das Verfahren effizienter ausgeführt werden.

Im Falle der Kombination verschiedener Eingabebilder mit komplementären Informationen kann darüber hinaus die Semantik der Repräsentation erhöht werden. Im Fall von komplementären Informationen kann die semantische Repräsentation noch aussagekräftiger und/oder effizienter werden. Bei der Repräsentation zur effizienten Speicherung und Analyse der Messungen ist daher eine kombinierte Eingabe der Messdaten in ein Netzwerk von Vorteil. Hierüber können z.B. Effekte voneinander getrennt werden, die z.B. je nach einem auftretenden Defekttyp in der Halbleiterstruktur in mindestens einer der Aufnahmen unterschiedlich auftreten. Bei Solarzellenausgangstests kann dies z.B. eine Kombination von Thermographie und Lumineszenz-Aufnahmen sein, die zur Vorhersage von Strom-Spannungsparametern (IV-Parametern) trainiert wurde. Die semantische Repräsentation kann dabei ermöglichen, mehr Defekte zu unterscheiden, die in einer der Aufnahmen alleine nicht sichtbar sind. Dadurch kann auf das manuelle Auswerten vieler verschiedener Abbildungen verzichtet werden und stattdessen die eine semantische Repräsentation zeiteffizient ausgewertet werden. Im Beispiel können Kurzschlüsse durch eine fehlerhafte Kantenisolation oder durch Risse verursacht werden. Kurzschlüsse können über ein erhöhtes Signal in der Thermographie identifiziert werden. Die Ursache des Defekts kann über die Erscheinung in der Lumineszenz-Messung identifiziert werden, worin beide Defekttypen eine unterschiedliche Bildsignatur zeigen. Bei der Materialbewertung im Eingangstest kann dies die Kombination von Photolumineszenz-Aufnahmen und Messungen der Reflexion oder Transmission sein, z.B. um rekombinationsaktive und nicht-rekombinationsaktive Korngrenzen voneinander zu unterscheiden.

Die semantische Repräsentation bietet also eine verständliche oder semantisch sinnvolle Darstellung von Daten, die bei der Produktion von Solarzellen erhoben werden können. Eine solche verständliche Aufbereitung der Daten kann benötigt werden, um Aufschlüsse über Prozess und Material zu erhalten. Die Messdaten können durch das Verfahren also in besonders geeigneter Weise komprimiert und gespeichert werden, um sie miteinander vergleichen zu können und relevante Informationen aus ihnen ziehen zu können. Insbesondere können relevante Merkmale (Repräsentation) aus den Bildern oder Abbildungen (Messdaten) extrahiert werden, um beispielsweise Qualitäts- und Prozessveränderungen von bei der Produktion verwendetem Material oder verwendeter Prozessschritte festzustellen zu können.

Aufgrund der hohen Durchsätze oder Stückzahlen pro Zeiteinheit bei einer Halbleiterproduktion oder Solarzellenproduktion wird weiterhin eine schnelle Kompression von Messdaten notwendig, die durch die Verwendung des neuronalen Netzes gewährleistet sein kann. Die semantische Repräsentation kann etwa genutzt werden, um Bilddaten effizient zu speichern. Die semantische Repräsentation kann ferner eine quantitative Datenanalyse mit semantischen sinnvollen Merkmalen zur Überwachung des Kristallisations- und Produktionsprozesses ermöglichen. Die Repräsentation kann somit zur Vorhersage von Solarzellenparameter verwendet werden. Eine solche Vorhersage kann es ermöglichen, Solarzellenparameter und/oder eine Qualitätsklasse der Solarzelle ohne kontaktierte Messverfahren zu bestimmen und somit einen Zeitbedarf bei der Charakterisierung der Halbleiterstruktur der Solarzelle zu verringern.

Vorteilhafterweise kann das erfindungsgemäße Verfahren also verwendet werden, um Daten effizient zu speichern und/oder zu komprimieren und dabei eine verständliche Darstellung und einen Informationsgehalt bezüglich der Halbleiterstruktur zugänglich zu machen und den Wert der Daten durch die geschaffene Vergleichbarkeit erhöhen. Weiterbildungen des Verfahrens können es ermöglichen, die Solarzellenqualität vorherzusagen und/oder zu klassieren (beispielsweise ein Zuordnen der Solarzelle umfassend die entsprechende Halbleiterstruktur in eine Qualitätsklasse), Prozess- und Materialfehler der Halbleiterstruktur voneinander zu trennen, und/oder die Kristallisation von Halbleiterstrukturen zu analysieren. Basierend darauf können beispielsweise Halbleiterprozesse überwacht und/oder optimiert werden.

Ein Vorteil des erfindungsgemäßen Verfahrens kann sein, dass bei der Analyse der Daten die semantische Repräsentation genutzt wird, die implizit die relevanten Bildinformationen hinsichtlich der gewünschten Qualitätsmerkmale enthält. Es können z. B. auch mehrere Bilddaten innerhalb dieser Repräsentation semantisch kombiniert werden. Hierüber können die Daten effizient gespeichert werden, effizient miteinander verglichen werden und Prozesse optimiert werden. Das Verfahren kann zur Analyse und Optimierung des Kristallisationsprozesses, zur Analyse und Optimierung des Solarzellenprozesses, zur Überwachung des Solarzellenproduktionsprozesses und/oder zum schnellen Bestimmen der Solarzellenklassierung mittels kontaktloser bildgebender Verfahren verwendet werden.

Um das Verfahren zu ermöglichen, kann beispielsweise zunächst das neuronale Netz trainiert werden. Dazu können Parameter der Halbleiterstruktur gemessen werden (beispielsweise in je einzelnen elektrischen Messungen, die das Bestimmen einzelner IV-Parameter ermöglichen), die später unter Verwendung des neuronalen Netzes vorhergesagt werden sollen (z.B. basierend auf einer einzigen bildgebenden Messung statt einer Vielzahl einzelner, elektrischer Messungen). Entsprechende Parameter können beispielsweise als Zielparameter bezeichnet werden. Entsprechend kann ein Verfahren ein Trainieren des neuronalen Netzes unter Verwendung von einer Vielzahl an Abbildungen jeweiliger Halbleiterstrukturen oder Solarzellen als Eingangsdaten sowie einer Vielzahl von gemessenen Eigenschaften der jeweiligen Solarzellen zugeordnet zu den entsprechenden Abbildungen als Ausgangsdaten umfassen. Die gemessenen Parameter können in Verbindung mit verschiedenen Abbildungen der jeweiligen Halbleiterstruktur verwendet werden, um das neuronale Netz zu trainieren. Durch die hohe Datenmenge ist es möglich, Ursachen für Veränderungen beispielsweise von Solarzellenparametern detaillierter bestimmen zu können.

Die gespeicherten semantischen Repräsentationen können, wie bereits erwähnt, dazu verwendet werden, Merkmale der Halbleiterstruktur wie Solarzellenparameter (IV-Parameter) oder Kristallisationsmerkmale vorherzusagen oder zu bestimmen. Zum Beispiel kann ein Verfahren zum Analysieren einer Kristallstruktur einer Halbleiterstruktur einer Solarzelle bereitgestellt werden und dafür ein Erzeugen einer Abbildung der Halbleiterstruktur der Solarzelle mittels eines erwähnten bildgebenden Verfahrens umfassen. Das Verfahren kann ferner ein Erzeugen einer semantischen Repräsentation basierend auf der Abbildung und unter Verwendung des trainierten neuronalen Netzes umfassen, sowie ein Ermitteln von Kristallisationsmerkmalen der Halbleiterstruktur der Solarzelle unter Verwendung der semantischen Repräsentation umfassen.

Somit kann die semantische Repräsentation für die Charakterisierung einer Solarzelle ebenso verwendet werden, wie für eine Charakterisierung eines reinen Halbleiterwafers oder eines Solarzellenvorläufers.

Ein Aspekt der Erfindung betrifft ein Verfahren zum Bestimmen zumindest einer Eigenschaft einer Solarzelle. Das Verfahren umfasst ein Verwenden einer semantischen Repräsentation einer mittels eines bildgebenden Verfahrens erzeugten Abbildung der Solarzelle oder eine Halbleiterstruktur der Solarzelle, wobei die semantische Repräsentation mittels eines neuronalen Netzes erzeugt ist, und ein Bestimmen der zumindest einen Eigenschaft der Solarzelle basierend auf der semantischen Repräsentation.

Mit anderen Worten kann das Verfahren verwendet werden, um basierend auf der Abbildung der Halbleiterstruktur und dem Verwenden der semantischen Repräsentation Parameter oder Eigenschaften der Solarzelle zu bestimmen. Die Verwendung der semantischen Repräsentation kann ein effizienteres Bestimmen der Parameter ermöglichen. Die Parameter können unter Verwendung eines neuronalen Netzes bestimmt werden. Zum Beispiel kann das neuronale Netz verwendet werden, welches zum Erzeugen der semantischen Repräsentation verwendet wurde.

Die zu bestimmenden Parameter oder Eigenschaften können Solarzellenparameter der Solarzelle betreffen. Die zumindest eine Eigenschaft kann beispielsweise eine Leerlaufspannung, einen Kurzschlussstrom, eine Kurzschlussstromdichte, einen Wirkungsgrad, einen Füllfaktor, einen Dunkelsättigungsstrom und/oder globale Solarzellenparameter wie etwa einen Serienwiderstand der Solarzelle umfassen.

Der Serienwiderstand kann beispielsweise mittels Photolumineszenz-Bildgebung der Solarzelle bestimmt werden, wobei die Zelle teilverschattet wird. Dabei werden im beleuchteten Teil Ladungsträger erzeugt, die in den unbeleuchteten Teil fließen. Es entsteht also ein interner Stromfluss durch den Serienwiderstand der Solarzelle, was im Lumineszenzbild sichtbar ist. Eine zweite Aufnahme wird erzeugt, wobei beleuchteter und unbeleuchteter Bereich komplementär zur ersten Aufnahme sind. Das Ergebnis wird aus den beiden Aufnahmen zusammengesetzt, indem die beleuchteten Bereiche aneinandergefügt werden, wobei Rechenschritte abhängig von der Beleuchtung u.a. erforderlich sein können. Durch die Verwendung der semantischen Repräsentation ist es möglich, statt der beiden einzelnen Aufnahmen oder Abbildungen die Information des Serienwiderstandes in einer einzigen semantischen Repräsentation darzustellen und zu speichern.

Beispielsweise betrifft die zumindest eine verfahrensgemäß zu bestimmende Eigenschaft ein ortsaufgelöstes Qualitätskriterium der Solarzelle. Beispielsweise kann ein Dunkelsättigungsstrom vorhergesagt werden. Ziele des Verfahrens können im Allgemeinen sein, eine semantische Repräsentation zu erzeugen, die semantische Repräsentation zu verfeinern und zeitaufwendige ortsaufgelöste Messungen zu ersetzen, indem sie nur während des Trainings eingesetzt werden müssen. Eine Erzeugung einer semantischen Repräsentation kann mittels einer Encoder-Decoder-Architektur erfolgen, wobei z.B. das Eingabebild (Input) aus inline-Messungen während des Solarzellenprozesses besteht und das Ausgebebild ein Qualitätsbild der Solarzelle ist. In einem konkreten Beispiel können Elektrolumineszenz-Aufnahme und Thermographie-Aufnahme bezüglich der Vorhersage des Bildes des Serienwiderstands und/oder dem Bild des Dunkelsättigungsstroms komprimiert werden. In einer kombinierten Auswertung (mittels Verwendung eines gemischten Modells umfassend Encoder-Decoder-Architektur und zugleich Regression/Klassifizierungs-Modell) von globalen und lokalen Qualitätswerten kann die Erzeugung der Repräsentation aus einer Optimierung des Netzwerkes bezüglich aller Vorhersageparameter vorgenommen werden. Dies wird z.B. über eine Gewichtung der Verlustfunktionen erreicht. Die Gewichtung der Verluste kann über den Lernprozess variieren. Insbesondere kann eine Kombination aus Repräsentationen aus unterschiedlichen Vorhersageparametern kombiniert werden, die wiederum zur Vorhersage eines weiteren Qualitätsparameters optimiert werden kann. Die Gewichtung der unterschiedlichen Verlustfunktionen kann über die Zeit variieren. Beispielsweise kann eine Teilrepräsentation aus der Vorhersage des Kurzschlussstromes, hingegen eine andere Vorhersage aus der Vorhersage der Offenklemmspannung und des Füllfaktors abgeleitet werden. In Kombination können die Merkmale weiterhin bezüglich der Vorhersage der Effizienz optimiert werden.

Beispielsweise kann das Verfahren ein Zuordnen der Solarzelle zu einer Qualitätsklasse basierend auf der zumindest einen mittels des Verfahrens bestimmten Eigenschaft umfassen. Der Vorteil kann sein, dass die Klassifizierung auf Grundlage der Abbildungen erfolgen kann und somit auf langwierige, kontaktierende Messungen zum Einordnen der Solarzellen in verschiedene Qualitätsklassen verzichtet werden kann.

Beispielsweise kann das Verfahren zur Charakterisierung von Solarzellen, allgemeinen Halbleiterstrukturen und/oder von Wafern verwendet werden. Dabei ist es möglich, aus einer Charakteristik oder aus Merkmalen eines Wafers wie beispielsweise Rissen, Korngrenzen, etc. auf Parameter der Solarzelle zurück zu schließen.

Beispiele betreffen dementsprechend die Charakterisierung von Solarzellen. Die Abbildungen, z.B. Lumineszenz-Aufnahmen (Elektrolumineszenz/Photolumineszenz), Thermographie-Aufnahmen und Reflexionsaufnahmen können wertvolle Informationen über den Solarzellenprozess enthalten, die nicht ausreichend für eine empirische Analyse in den Bildern quantifiziert sind. Beispielsweise kann es bei der Charakterisierung von Solarzellen ein Ziel sein, Parameter vorherzusagen (Vorhersageparameter), die einzelne Parameter darstellen. In einem faltenden neuronalen Netz wird dazu zum Beispiel ein Vorhersagemodell zur Vorhersage der IV-Parameter (IV: Strom-Spannung) trainiert. Aus einer oder mehrerer Schichten des neuronalen Netzes wird die semantische Repräsentation der Daten entnommen und gespeichert. Dies kann in einem multivariaten Netzwerk zur Vorhersage aller IV-Parameter beispielsweise die Schicht vor dem letzten Regressionsschritt jedes Vorhersageparameters sein. Alternativ kann der Vorhersageparameter eine ortsaufgelöste Vorhersage umfassen. Das Netzwerk kann dementsprechend zum Beispiel bezüglich der Vorhersage eines oder mehrere ortsaufgelösten Qualitätsparameters (zum Beispiel Dunkelsättigungsstrom) optimiert werden. Die Vorhersage der Dunkelsättigungsstromdichte verstärkt beispielsweise die Erfassung der rekombinationsaktiven Strukturen die relevant für die Solarzelle sind und einen starken Materialbezug aufweisen. Die Vorhersage des Bildes des Serienwiderstands verstärkt zum Beispiel die Repräsentation von Widerstandseffekten.

Alternativ kann der Vorhersageparameter eine kombinierte Messung umfassen. Die Vorhersage kann bezüglich der kombinierten Vorhersage mehrerer einzelner und/oder ortsaufgelöster Messungen optimiert werden. Hierbei kann die Repräsentation aus verschiedenen Teilen des Netzes kombiniert werden. So kann beispielsweise das Netzwerk so gestaltet sein, dass unterschiedliche Teile der semantischen Repräsentation zur Vorhersage der ortsaufgelösten oder globalen Information optimiert werden und in Kombination zur Vorhersage eines anderen Parameters, zum Beispiel zur Vorhersage der Effizienz der Solarzelle, optimiert werden.

Die semantischen Repräsentationen ermöglichen einen Vergleich unterschiedlicher Proben, z.B. von Solarzellen, da der Abstand zwischen den Proben über die semantische Repräsentation berechnet werden kann. Somit können die Daten mittels statistischer Verfahren, wie überwachten und unüberwachten maschinellen Lernverfahren, analysiert werden. Hierbei können auch IV-Daten zur Analyse berücksichtigt werden. Es können beispielsweise spezifische Defektphänomene über eine Clusteranalyse identifiziert werden. Zur Analyse können Analyseverfahren wie hierarchische Clusteringverfahren, k-means Clustering, EM-Algorithmus, selbstorganisierende Karten, Embedding-Techniken (z.B. t-SNE) oder andere herangezogen werden.

Durch die Analyse oder Charakterisierung der Halbleiterstruktur können Phänomene ermittelt werden. Phänomene die dabei zum Vorschein treten können, sind Messfehler bei der Kontaktierung, Kurzschlüsse in der Solarzelle durch Umgriffe, Kurzschlüsse in der Solarzelle durch Risse, eine Senkung des Serienwiderstandes durch Fingerunterbrechungen oder eine fehlerhafte Kontaktierung der Leiterbahnen mit der Halbleiterstruktur der Solarzelle, unterschiedliche Einflussfaktoren des Materials die sich auf Wirkungsgrad und Leerlaufspannung auswirken, wie der Lebensdauer der Überschussladungsträger, die Verteilung von rekombinationsaktiven Störstrukturen durch Versetzungen, die Verteilung von Materialdefekten aufgrund von Tiegelkontaminationen, die die Lebensdauer der Überschussladungsträger reduzieren und/oder ein Einfluss der Antireflexbeschichtung oder die Abschattung aufgrund der Breite der Kontakteinheiten auf den Kurzschlussstrom.

Beispielsweise kann ein Phänomen bedingt durch eine Veränderung eines Halbleiterprozesses ein Sinken des Serienwiderstandes der Solarzelle sein. Die Analyse gemäß dem Verfahren kann es ermöglichen, dem Phänomen beispielsweise die Ursache zuzuordnen, dass Fingerunterbrechungen vorliegen. Entsprechend kann diese Information genutzt werden, um die Ursachenquelle zu beseitigen und dadurch den Halbleiterprozess wieder zu verbessern.

Das Analysieren der Halbleiterstruktur, also beispielsweise der Solarzelle oder des Wafers, basieren auf der semantischen Repräsentation ermöglicht mit anderen Worten eine genauere oder detailliertere Betrachtung als basierend allein auf den IV-Parametern. Dies ist darauf zurückzuführen, dass die semantische Repräsentation eine Vielzahl weiterer Informationen über die Halbleiterstruktur aufweist, die genutzt werden können, um beispielsweise die IV-Parameter zu bestimmen. Jedoch ermöglichen die bereitgestellten Zusatzinformationen z.B. auch Ursachen oder Phänomene bestimmen zu können, die das zustande kommen der entsprechenden IV-Paramater erklären können.

Ein Vorteil an der Verwendung der semantischen Repräsentation und des neuronalen Netzwerkes zum Ermitteln von Phänomenen kann ferner sein, dass aufgrund der großen Datenmengen und Bildinformationen, die verarbeitet werden können, Phänomene ermittelt werden können, die basierend auf einer manuellen Auswertung der Abbildungen unentdeckt bleiben könnten. Dadurch kann das erfindungsgemäße Verfahren eine Charakterisierung oder Analyse der Halbleiterstrukturen verbessern.

Es ist weiterhin möglich, Visualisierungstechniken zur Analyse der Repräsentationen einzusetzen. Dadurch können beispielsweise Ursachen von Effekten oder Parametervariationen für eine manuelle Auswertung oder Erkennung in verständlicher Weise dargestellt werden. Im Rahmen von Embedding-Techniken kann die Dimension der Repräsentation noch weiter reduziert werden, wobei beispielsweise der Abstand zwischen den Repräsentationen im komprimierten Datenraum erhalten bleibt. Im niedrig-dimensionalen Embedding-Raum können etwa benachbarte Aufnahmen und Qualitätswerte visualisiert werden. Bei überwachten Lernmethoden kann die Verwendung von Zielparametern zur Gruppierung von Repräsentationen berücksichtigt werden.

Beispielsweise ist es möglich, das Verfahren auch zur Charakterisierung von Wafern zu nutzen, etwa um eine Materialqualität zu prüfen. Bei der Charakterisierung von Wafern nach dem Sägeprozess werden typischerweise Photolumineszenz-Aufnahmen, sowie Transmission und Reflexionsmessungen mit variierendem Beleuchtungsaufbau, z.B. Beleuchtungswinkel, als Eingabe für ein Netzwerk berücksichtigt. Die Photolumineszenz-Aufnahmen erfassen dabei rekombinationsaktive Defekte. Transmissions-Aufnahmen erfassen Risse und Metall-Einschlüsse. Reflexionsmessungen erfassen die Kornstruktur.

Die semantische Repräsentation kann daher Informationen über die Halbleiterstruktur oder den Wafer enthalten, die ansonsten nur in einer Mehrzahl separater Abbildungen erfassbar wären und gespeichert werden könnten.

Beispielsweise können einzelne Parameter des Wafers vorhergesagt werden (Vorhersageparameter = einzelner Parameter). Das Netzwerk wird beispielsweise zur Vorhersage des Qualitätsparameters trainiert, wobei die Leerlaufspannung oder Effizienz geeignete Parameter sind. Alternativ können ortsaufgelöste Messungen durchgeführt werden (Vorhersageparameter = ortsaufgelöste Messung). Das Netzwerk kann beispielsweise bezüglich der Vorhersage eines oder mehrere ortsaufgelösten Qualitätsparameters optimiert werden. Die Vorhersage der Dunkelsättigungsstromdichte verstärkt beispielsweise die Erfassung der rekombinationsaktiven Strukturen die relevant für die Solarzelle sind. Die Detektion der Korngrenzen verstärkt die Repräsentation der Kornverteilung. Alternativ können kombinierte Messungen durchgeführt werden (Vorhersageparameter = kombinierte Messung). Die Vorhersage kann bezüglich der kombinieten Vorhersage mehrere einzelner sowie ortsaufgelöster Messungen optimiert werden. Hierbei kann die Repräsentation aus verschiedenen Teilen des Netzes kombiniert werden.

Phänomene die bei der Analyse der semantischen Repräsentation des Wafers festgestellt werden können, sind beispielsweise Materialdefekte durch rekombinationsaktive Störstellen, rekombinationsaktive Korngrenzen, nicht-rekombinationsaktive Korngrenzen, Kontaminationen durch den Tiegel, eine reduzierte Ladungsträgerlebensdauer durch Randkontaminationen, Einschlüsse von Metall und/oder starke Sägeriefen auf der Oberfläche oder eine Art der Homogenität der Kornverteilung.

Beispielsweise kann es rein basierend auf Abbildungen der Halbleiterstruktur schwierig sein, verschiedene Halbleiterstrukturen miteinander zu vergleichen. Daher ist in einem Ausführungsbeispiel verfahrensgemäß vorgesehen, die semantische Repräsentation zum Vergleich der Halbleiterstruktur mit einer anderen Halbleiterstruktur zu verwenden. Dies erfolgt zum Beispiel unter Verwendung einer zur anderen Halbleiterstruktur korrespondierenden semantischen Repräsentation zum Ermitteln von Informationen der Halbleiterstrukturen und/oder eines Halbleiterprozesses zum Bearbeiten der Halbleiterstrukturen.

Mit anderen Worten kann das verfahrensgemäße Verwenden von semantischen Repräsentationen ermöglichen, sowohl Phänomene der unterschiedlichen Halbleiterstrukturen miteinander zu vergleichen, als auch den Einfluss von Prozessschritten auf die Halbleiterstruktur zu ermitteln. Dazu können semantische Repräsentationen einer oder mehrerer Halbleiterstrukturen oder Proben verwendet werden. Es kann möglich sein, semantische Repräsentationen miteinander zu vergleichen, die auf Abbildungen unterschiedlicher bildgebender Methoden basieren. Der Vergleich von Halbleiterstrukturen basierend auf der semantischen Repräsentation ermöglicht einen schnellen und effizienten Vergleich von relevanten Merkmalen (zum Beispiel bezüglich der Qualität der Solarzelle oder der Solarzellenparameter).

Entsprechend ist in einem Ausführungsbeispiel des Verfahrens ein Bearbeiten der Halbleiterstruktur in einem Halbleiterprozess vorgesehen. Das Verfahren umfasst ein Erzeugen einer weiteren Abbildung umfassend die Halbleiterstruktur nach dem Halbleiterprozess und ein Nutzen der weiteren Abbildung zum Erzeugen der semantischen Repräsentation, zusätzlich zur Abbildung. Ferner umfasst das Verfahren ein Bestimmen von Parametern des Halbleiterprozesses unter Verwendung der semantischen Repräsentation.

Das Verfahren ermöglicht somit basierend auf der Verwendung der semantischen Repräsentationen eine schnelle Evaluierung des Halbleiterprozesses oder einzelner Schritte des Halbleiterprozesses. Insbesondere kann auf effiziente Weise ermittelt werden, welchen Einfluss ein Halbleiterprozessschritt oder mehrere Halbleiterprozessschritte auf Parameter der Solarzelle oder des Wafers haben können.

Ein weiterer Aspekt der Erfindung betrifft ein Verfahren zum Charakterisieren eines Halbleiterprozesses. Das Verfahren umfasst ein Verwenden von Halbleiterstrukturen jeweiliger Solarzellen und ein Bearbeiten der Halbleiterstruktur in einem Halbleiterprozess mit vorbestimmten Prozessparametern. Ferner umfasst das Verfahren ein Erzeugen jeweiliger, den Halbleiterstrukturen zugeordneten semantischen Repräsentationen von Abbildungen umfassend die jeweilige Halbleiterstruktur sowie ein Verwenden der semantischen Repräsentationen in Verbindung mit den vorbestimmten Prozessparametern, zum Bestimmen von Prozessphänomenen.

Es kann also vor und nach einem Prozessschritt eines Halbleiterprozesses eine jeweilige Abbildung der Halbleiterstruktur erzeugt werden und basierend darauf können semantische Repräsentationen bzw. jeweilige semantische Repräsentationen erzeugt werden. Beispielsweise besteht ein zweites Modell zur Bestimmung des Prozesseinflusses aus Messungen vor und nach einem oder mehreren Prozessschritten. Aufgrund eines Vergleichs und/oder einer Verarbeitung und/oder einer Analyse der semantischen Repräsentation der Halbleiterstruktur vor dem Prozessschritt und nach dem Prozessschritt ist es möglich, den Prozessschritt zu charakterisieren. Mit anderen Worten kann das Verfahren ermöglichen, die Parameter zu bestimmen, welche einen Prozessschritt ausmachen. Beispielsweise kann erkannt werden, welchen Einfluss ein bestimmter Prozessschritt auf einen bestimmten Solarzellenparameter hat. Mittels des Vergleichs kann beispielsweise ein Vorhersagefehler, der den Einfluss von Halbleiterprozessschritten darstellen kann, ermittelt werden.

Zum Beispiel können Abbildungen von Halbleiterstrukturen in den verschiedenen Prozessschritten im Rahmen einer semantischen Repräsentation zur Vorhersage von Prozessphänomenen verknüpft werden. Das Prozessphänomen kann sich aus dem Vergleich des Vorhersagewertes vor Prozess mit dem echten Qualitätswert ergeben. Man kann beispielsweise auch den Vorhersagewert vor Prozess mit dem Vorhersagewert nach Prozess vergleichen.

Basierend auf der Charakterisierung des Halbleiterprozesses ist es möglich, ein Verfahren zum Verbessern oder Optimieren des Halbleiterprozesses oder zur Prozessoptimierung bereitzustellen. Dementsprechend kann das Verfahren ein Anpassen der Prozessparameter unter Verwendung der zuvor bestimmten Prozessphänomene umfassen. Sowohl Verfahren zur Charakterisierung von Halbleiterstrukturen als auch zur Optimierung von Halbleiterprozessen können eine jeweilige Ähnlichkeit zwischen entsprechenden semantischen Repräsentationen als Grundlage nutzen.

Wenn zum Beispiel die semantische Repräsentation nach dem Prozessschritt indiziert, dass eine Qualität der Solarzellenparameter durch den Prozessschritt abgenommen hat, ist es möglich einen oder mehrere Prozessparameter anzupassen, um die Qualität der Solarzellenparameter nach dem Prozessschritt zu erhöhen. Beispielsweise können dazu entsprechende Prozessparameter aufgrund von a-priori-Wissen eingestellt oder justiert werden. Alternativ können die Prozessparameter sukzessive verändert werden (Reinforcement-Leaming; beispielsweise erhöht oder verringert) und jeweilige Veränderungen der semantischen Repräsentation nach dem Prozessschritt beobachtet werden. Dadurch ist es möglich, herauszufinden, welche Art der Justierung der Prozessparameter eine Erhöhung der Qualität der Solarzellenparameter (oder anderer Parameter der Halbleiterstruktur) ermöglicht.

Beispielweise ist es möglich, eine Prozessfehlerinformation auszugeben, etwa im Fall, dass nach einem Halbleiterprozess eine Abweichung einer Eigenschaft der Solarzelle von einer Standardeigenschaft auftritt, obwohl eine semantische Repräsentation, die auf einer vor dem Halbleiterprozess erzeugten Abbildung der Halbleiterstruktur der Solarzelle basiert, einer Standard-Repräsentation entspricht. Eine Standard-Repräsentation kann beispielsweise eine durchschnittliche semantische Repräsentation solcher Halbleiterstrukturen darstellen, die einer bestimmten, beispielsweise einer hohen, Qualitätsklasse zugeordnet sind. Dadurch ist es z.B. möglich, Prozessfehler von Materialfehlern zu unterscheiden. Wenn die semantische Repräsentation vor dem Halbleiterprozess indiziert, dass die Halbleiterstruktur eine hohe Güte oder eine hohe Qualität aufweist, und die semantische Repräsentation nach dem Halbleiterprozesses eine geringere Qualität indiziert (beispielsweise kann zusätzlich oder alternativ ein Messwert der Probe oder Halbleiterstruktur selbst verwendet werden), kann mit hoher Wahrscheinlichkeit von einem Prozessfehler ausgegangen werden, wohingegen z.B. grundsätzliche Materialfehler ausgeschlossen werden können.

Es werden weitere Beispiele zu einer möglichen Verfahrens gemessen Prozesscharakterisierung oder Prozessoptimierung gegeben. Die semantische Repräsentation ermöglicht beispielsweise eine Charakterisierung der Solarzelle in verschiedenen Stadien des Fertigungsprozesses. Die Repräsentationen für einen Prozess können miteinander verglichen werden. Sie verändern sich mit der Zeit, den gewählten Prozessparametern der Vorprozesse, der Materialqualität etc. Zur Prozessanalyse können die Repräsentationen unter Berücksichtigung weiterer Parameter, wie der Prozesszeit, eines Prozessparameters, der Position im Prozessboot oder der Position des Wafers im Kristall untersucht werden.

Es ist weiterhin möglich, einen Kristallisationsprozess zu analysieren. Eine semantische Repräsentation eines Wafers ermöglicht einen Vergleich der Kristallisationsprozesse. Hierzu können die semantischen Repräsentationen von Wafern unterschiedlicher Kristallisationen miteinander verglichen werden. Insbesondere können hierbei jeweils Proben aus dem gleichen Bereich der Bricks verglichen werden. Über die Abstände der jeweiligen semantischen Repräsentationen kann eine Ähnlichkeit der Kristallisation und die Homogenität des Prozesses analysiert werden. Auch können Abweichungen in verschiedenen Bereichen des Bricks identifiziert werden.

Beispielsweise können Halbleiterwafer analysiert werden. Die Wafer-Repräsentation (semantische Repräsentation des Wafers) ermöglicht zum Beispiel eine Bewertung des Kristallisationsprozesses. Hierzu können etwa die Proben eines Bricks unter Berücksichtigung der Höheninformation verglichen werden. Beispielsweise deutet ein geringer Abstand zwischen benachbarten Proben auf einen homogenen Prozess hin. Ein starker Gradient kann dagegen auf ein Ereignis im Prozess hinweisen. Bei Auftreten einer starken Abweichung zwischen zwei zeitlich hintereinander erstellten semantischen Repräsentationen kann beispielsweise eine genauere Untersuchung des Prozesses erfolgen, um eventuelle Fehlerquellen ausschließen zu können.

Beispielsweise können Solarzellenprozesse analysiert werden. Die Solarzellen-Repräsentation (semantischen Repräsentation einer Solarzelle) ermöglicht einen Vergleich des Solarzellenprozesses. Hierzu kann man die Repräsentation von Solarzellen mit natürlichen oder gezielten Prozessvariationen (verschiedene Einstellungen von Prozessparametern eines Halbleiterprozesses) miteinander vergleichen. Zur Analyse der Prozessstabilität können die semantischen Repräsentationen unter Berücksichtigung des Prozesszeitpunktes miteinander verglichen werden. Beispielsweise deutet ein geringer Abstand zwischen den semantischen Repräsentationen zeitlich benachbarter Proben auf einen homogenen Prozess hin. Ein starker Gradient kann dagegen auf ein Ereignis im Prozess hinweisen. Diese Ereignisse können unter Berücksichtigung der analysierten Phänomene bewertet werden. Die Repräsentation kann zum Beispiel einen Materialeinfluss darstellen.

Beispielsweise können Halbleiterprozesse optimiert werden. Zum Beispiel wird bei der Optimierung des Solarzellenprozesses die Verbesserung der Solarzellenqualität angestrebt. Hierzu soll eine Prozessanpassung (Aktion/Justierung der Prozessparameter) erfolgen, die den momentanen Zustand so verändert, dass die Solarzellenqualität gesteigert wird. Im Beispiel des Lernens durch Verstärkung ist das Wissen um den Effekt des Zustand-Aktion Paares entscheidend für den Optimierungsprozess. Die reine Information über die momentane Prozesskonfiguration ist aber unter Umständen nicht aufschlussreich genug, um den tatsächlichen Zustand zu beschreiben. Die semantische Repräsentation durch das Netzwerk erlaubt zusätzliche Informationen (beispielsweise im Gegensatz zu reinen IV-Parametern), die bei der Optimierung der Prozesse berücksichtigt werden müssen. Beispielsweise können für eine herkömmliche Prozessoptimierung neben den Prozessparametern nur vier Strom-Spannung-Parameter der Solarzelle zur Verfügung stehen. Die semantische Repräsentation dagegen kann eine Vielzahl weiterer Informationen der Halbleiterstruktur, die Einfluss auf die Qualität der Solarzelle haben können, umfassen. Dies kann beispielsweise die Materialqualität sein, die in der Repräsentation des Wafers enthalten ist. Im Falle der semantischen Repräsentation der Solarzelle erfasst die Messung sowohl material- als auch prozessbezogene Phänomene.

Ein Aspekt des Verfahrens betrifft zusammenfassend den Vergleich von semantischen Repräsentationen verschiedener Halbleiterstrukturen untereinander. Eine Ähnlichkeit bzw. Abweichung zwischen zwei semantischen Repräsentationen kann dazu genutzt werden, eine Charakterisierung der Halbleiterstruktur vorzunehmen (bspw. Ähnlichkeit bzw. Abweichung zu einer Standard-Struktur mit einer Standard-Repräsentation) oder eine Prozessoptimierung vorzunehmen.

Durch das Verfahren kann also ermöglicht werden, eine Analyse einer Vorstufe eines Wafers, eines Wafers, einer Vorstufe einer Solarzelle oder einer Solarzelle durchzuführen.

Entsprechend können Prozesse der einzelnen Stadien der Solarzellenproduktion optimiert werden. Insgesamt lässt sich somit durch das Verfahren z.B. eine Qualität des gesamten Solarzellenprozesses verbessern.

Ein weiterer Aspekt der Erfindung betrifft ein Verfahren zur Bewertung abgeschatteter Bereiche in ortsaufgelösten Qualitätsbildern von Halbleiterstrukturen. Das entsprechende Verfahren umfasst ein Verwenden einer semantischen Repräsentation des Qualitätsbildes der Halbleiterstruktur und ein Verarbeiten der semantischen Repräsentation in einem neuronalen Netzwerk, um eine erste und eine zweite Signalausgabe zu erzeugen. Ferner wird zumindest ein lokaler Parameter durch Auswerten der ersten Signalausgabe umfassend Informationen von nicht-abgeschatteten Bereichen der Halbleiterstruktur bestimmt und zumindest ein globaler Parameter durch Auswerten der zweiten Signalausgabe umfassend Informationen der gesamten Halbleiterstruktur bestimmt. Das Verfahren umfasst ein Bestimmen zumindest eines Merkmals eines abgeschatteten Bereiches unter Verwendung des zumindest einen lokalen Parameters und des zumindest einen globalen Parameters.

Es ist somit möglich, basierend auf dem Verfahren auch Parameter von Bereichen vorherzusagen, die auf der Abbildung nicht dargestellt sind, da sie verdeckt oder abgeschattet sind. Aus den globalen Informationen und den Informationen der nicht-verdeckten Bereiche der Halbleiterstruktur ist es z.B. möglich, Rückschlüsse auf die abgeschatteten Bereiche zu ziehen. Dadurch können z.B. weitere Messungen der Halbleiterstruktur vermieden werden und dennoch ortsaufgelöste Parameter der auf der Abbildung abgedeckten Bereiche oder Informationen über die abgedeckten Bereiche bereitgestellt werden. Beispielsweise wenn das Lernen abgeschatteter Bereiche an die semantische Repräsentation geknüpft ist, kann ferner gelten, dass aus dem Modell zur Vorhersage abgeschatteter und nicht abgeschatteter Bereiche eine semantische Repräsentation abgeleitet werden kann, die wertvoller auf Grund der Zusatzinformationen in abgeschatteten Bereiche ist.

Das Vorhersagen des Parameters oder mehrerer Parameter gleichzeitig kann mittels der Verwendung der semantischen Repräsentation und des neuronalen Netzes in einem einzigen Schritt erfolgen, da mittels des neuronalen Netzes auf Grundlage der Abbildung alle Parameter auf einmal bestimmt werden können. Ein hoher Zeitbedarf kann somit verschoben werden und allein, z.B. bei der Erhebung des Trainingdatensatzes, und beim Training des neuronalen Netzes entstehen. Das Bestimmen der Parameter der Halbleiterstruktur auf Grundlage der semantischen Repräsentation dagegen kann innerhalb weniger Zehntelsekunden, bspw. in weniger als 100 ms erfolgen.

Beispielsweise kann das Verfahren genutzt werden, um eine Vorhersage einer Auswirkung eines Halbleiterprozesses zu ermöglichen. Ein Einfluss eines Prozessschrittes kann durch Kombination der Messungen vor und nach dem Prozessschritt bestimmt werden. Zum Beispiel kann der Einfluss eines Prozesses in einem Prozessschritt auf die Qualität der Solarzelle (Reflexion, IV-Parameter, etc.) untersucht werden. Hierzu werden z.B. Daten mit unterschiedlichen Prozesseigenschaften oder natürlichen Prozessstreuungen erhoben. In Folge kann ein Modell oder neuronales Netz zur Qualitätsvorhersage mit aussagekräftigen Messungen vor dem eigentlichen Prozess trainiert werden. Dadurch kann ein Vorhersagefehler ermittelt werden. Der Vorhersagefehler stellt z.B. den möglichen Prozesseinfluss der Folgeprozesse dar. Im Folgenden kann ein Modell zur Vorhersage des Prozesseinflusses mit den kombinierten Messdaten, die vor und nach dem Prozessschritt erhoben wurden, trainiert werden.

Mittels der semantischen Repräsentation können dabei in vorteilhafter Weise wesentliche Unterschiede, die durch den Prozess entstanden sind, erfasst werden. Die Charakterisierungsmethoden können zur Identifikation unterschiedlicher Prozessergebnisse/Phänomene genutzt werden. Ebenso kann über Aktivierungskarten eine lokale Ursache für Phänomene identifiziert werden. Damit ist es möglich, eine Prozesscharakterisierung zu verbessern und ebenso Fehlerquellen genauer lokalisieren zu können.

Beispielsweise spiegeln Photolumineszenz-Messungen im Wafer-Zustand (vor allem rohe oder unbehandelte Wafer-Scheiben) vor allem Materialeigenschaften wider. Eine Vorhersage der Solarzellenqualität ist in diesem Stadium z.B. nur bedingt möglich. Es kann einen Fehler bei der Vorhersage der Solarzelleneffizienz oder anderer IV-Parameter geben. Das Verfahren sieht deshalb vor, dass ein Modell zur Vorhersage der Leerlaufspannung trainiert wird, um daraus den Vorhersagefehler für Photolumineszenz-Aufnahmen von Wafern zu ermitteln. Daraufhin kann ein neuronales Netzwerk derart trainiert werden, dass die Eingabe aus Photolumineszenz-Aufnahme des Wafers und Aufnahmen der Solarzelle z.B. Elektrolumineszenz oder Photolumineszenz an der Solarzelle, kombiniert wird, um den Prozess- oder Messungs-bedingten Einfluss vorherzusagen und somit vom Materialeinfluss zu trennen.

Ein weiteres Beispiel betrifft die Analyse des Kurzschlussstroms. In einem Prozessschritt nach einer Oberflächenstrukturierung der Halbleiterstruktur ("texturiert") kann der Einfluss auf den Kurzschlussstrom analysiert werden, indem die diffuse Reflexion der Probe gemessen wird. Der Vorhersagefehler des Kurzschlussstroms anhand der Messung der diffusen Reflexion kann den Prozesseinfluss der Folgeprozesse darstellen. Nach der Antireflexbeschichtung kann erneut die Reflexionseigenschaft bei ausgewählten Wellenlängen gemessen werden. Wird diese Messung mit der Messung nach der Textur als Eingabe für ein neuronales Netz zur Vorhersage des Kurzschlussstroms kombiniert, kann ein Modell zur Vorhersage des Prozesseinflusses bereitgestellt werden. Die semantische Repräsentation dieses Modells kann zur Analyse und dem Vergleich von Prozessen zur Antireflexbeschichtung verwendet werden.

Ein Beispiel eines Verfahrens betrifft ein Vorhersagen von zumindest einer Eigenschaft einer Solarzelle. Das Verfahren umfasst entsprechend ein Erzeugen zumindest einer Abbildung einer Halbleiterstruktur der Solarzelle mittels eines bildgebenden Verfahrens nach einem oder verschiedenen Prozessschritten während der Herstellung der Solarzelle, wobei die Abbildung zumindest Informationen bezüglich rekombinationsaktiver Defekte der Halbleiterstruktur, bezüglich Prozessfehlern bei der Herstellung, bezüglich Stromeinträgen der Solarzelle bei unterschiedlichen Anregungsbedingungen oder bezüglich einem Serienwiderstand der Solarzelle umfasst. Das Verfahren umfasst ferner ein Vorhersagen der Eigenschaft mittels eines unter Verwendung von Messergebnissen kontaktierter Eigenschaftsmessungen trainierten neuronalen Netzes, um mittels kontaktloser Messungen die Eigenschaft der Solarzelle vorherzusagen, wobei die Eigenschaft zumindest eines aus einem Wirkungsgrad der Solarzelle, eines Kurzschlussstroms der Solarzelle, einer Leerlaufspannung der Solarzelle oder einem Füllfaktor der Solarzelle umfasst.

Durch die Verwendung des neuronalen Netzes zum Vorhersagen der Solarzellenparameter kann beispielsweise beim Bestimmen der Parameter auf elektrische Messungen verzichtet werden und die Parameter können allein basierend auf einer Abbildung der Halbleiterstruktur bestimmt werden. Zum Beispiel ermöglicht es das Verfahren unter Verwendung des Netzwerks oder neuronalen Netzwerks, zur Charakterisierung oder Analyse der Halbleiterstruktur statt elektrischer oder physikalischer Kontaktmessungen der Halbleiterstruktur Messergebnisse bildgebender Verfahren zu nutzen. Dies ermöglicht es z.B. eine Zeitdauer für die Charakterisierung der Halbleiterstruktur zu verringern. Ein Zeitaufwand zum Trainieren des neuronalen Netzes kann nur einmal erforderlich sein. Beispielsweise können basierend auf einer einzigen Abbildung mehrere Parameter auf einmal bestimmt werden. Das Verfahren ermöglicht somit eine Charakterisierung oder Qualitätsbestimmung von Halbleiterstrukturen in Serienproduktion, da knappe Zeitvorgaben erfüllt werden können.

### Figurenkurzbeschreibung

Einige Beispiele von Vorrichtungen und/oder Verfahren werden nachfolgend bezugnehmend auf die beiliegenden Figuren lediglich beispielhaft näher erläutert. Es zeigen:
- Fig. 1: ein Flussdiagramm eines Verfahrens zum Verarbeiten einer Abbildung einer Halbleiterstruktur;
- Fig. 2: ein Flussdiagramm eines Verfahrens zum Bestimmen einer Eigenschaft einer Solarzelle;
- Fig. 3: ein Flussdiagramm eines Verfahrens zum Verbessern eines Halbleiterprozesses;
- Fig. 4: ein Flussdiagramm eines Verfahrens zur Bewertung ortsaufgelöster Qualitätsbilder;
- Fig. 5: ein Flussdiagramm eines Verfahrens zum Vorhersagen einer Eigenschaft einer Solarzelle;
- Fig. 6a-c: Architekturen von neuronalen Netzen mit semantischen Repräsentationen;
- Fig. 7: eine schematische Darstellung eines Verfahrens zur Kalibrierung ortsaufgelöster Qualitätsmessungen;
- Fig. 8: eine schematische Darstellung eines Verfahrens zur Bewertung abgeschatteter Bereiche in ortsaufgelösten Qualitätsbildern;
- Fig. 9: ein Verfahren zum Training eines Modells zur Bestimmung eines Prozesseinflusses; und
- Fig. 10: ein Verfahren zur Bestimmung oder Analyse des Prozesseinflusses.

### Beschreibung

Verschiedene Beispiele werden nun ausführlicher Bezug nehmend auf die beiliegenden Figuren beschrieben, in denen einige Beispiele dargestellt sind. In den Figuren können die Stärken von Linien, Schichten und/oder Bereichen zur Verdeutlichung übertrieben sein.

Während sich weitere Beispiele für verschiedene Modifikationen und alternative Formen eignen, sind dementsprechend einige bestimmte Beispiele derselben in den Figuren gezeigt und werden nachfolgend ausführlich beschrieben. Allerdings beschränkt diese detaillierte Beschreibung weitere Beispiele nicht auf die beschriebenen bestimmten Formen. Weitere Beispiele können alle Modifikationen, Entsprechungen und Alternativen abdecken, die in den Rahmen der Offenbarung fallen. Gleiche oder ähnliche Bezugszeichen beziehen sich in der gesamten Beschreibung der Figuren auf gleiche oder ähnliche Elemente, die bei einem Vergleich miteinander identisch oder in modifizierter Form implementiert sein können, während sie die gleiche oder eine ähnliche Funktion bereitstellen.

Es versteht sich, dass, wenn ein Element als mit einem anderen Element "verbunden" oder "gekoppelt" bezeichnet wird, die Elemente direkt, oder über ein oder mehrere Zwischenelemente, verbunden oder gekoppelt sein können. Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht explizit oder implizit anders definiert. Eine alternative Formulierung für die gleichen Kombinationen ist "zumindest eines von A und B" oder "A und/oder B". Das Gleiche gilt, mutatis mutandis, für Kombinationen von mehr als zwei Elementen.

Die Terminologie, die hier zum Beschreiben bestimmter Beispiele verwendet wird, soll nicht begrenzend für weitere Beispiele sein. Wenn eine Singularform, z. B. "ein, eine" und "der, die, das" verwendet wird und die Verwendung nur eines einzelnen Elements weder explizit noch implizit als verpflichtend definiert ist, können weitere Beispiele auch Pluralelemente verwenden, um die gleiche Funktion zu implementieren. Wenn eine Funktion nachfolgend als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei Gebrauch das Vorhandensein der angegebenen Merkmale, Ganzzahlen, Schritte, Operationen, Prozesse, Elemente, Komponenten und/oder einer Gruppe derselben präzisieren, aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

Sofern nicht anderweitig definiert, werden alle Begriffe (einschließlich technischer und wissenschaftlicher Begriffe) hier in ihrer üblichen Bedeutung auf dem Gebiet verwendet, zu dem Beispiele gehören.

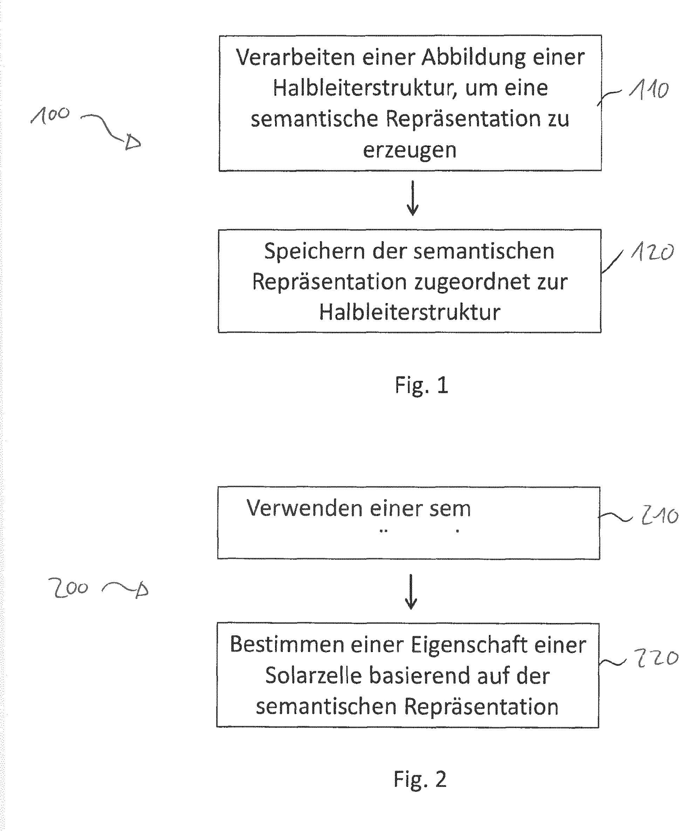

Fig. 1 zeigt ein Verfahren 100 zum Verarbeiten von unter Verwendung von bildgebenden Verfahren erzeugten Abbildungen einer Halbleiterstruktur einer Solarzelle. Das Verfahren 100 umfasst ein Verarbeiten 110 der Abbildung der Halbleiterstruktur mittels eines trainierten neuronalen Netzes, um eine semantische Repräsentation der Abbildung zu erzeugen. Eine Datengröße der verfahrensgemäß erzeugten semantischen Repräsentation ist dabei geringer als eine Datengröße der Abbildung. Ferner umfasst das Verfahren 100 ein Speichern 120 der semantischen Repräsentation zugeordnet zur Halbleiterstruktur. Die semantische Repräsentation stellt dabei einen Informationsträger von relevanten Informationen der Abbildung bereit, die für ein Bestimmen einer Eigenschaft der Solarzelle und/oder für eine Kristallanalyse einer Halbleiterstruktur der Solarzelle verwendet werden können.

Die Halbleiterstruktur kann beispielsweise ein Wafer sein, der zur Herstellung der Solarzelle verwendet wird. Die Abbildung kann eine Photolumineszenz-Aufnahme des Wafers sein. Zur Vorhersage der Solarzellenparameter anhand von Photolumineszenz-Aufnahmen an einem as-cut Wafer können Verfahren verwendet werden, gemäß denen bestimmte Merkmale extrahiert werden, die manuell definiert werden. Gemäß dem beispielhaften Verfahren werden die Merkmale indirekt anhand einer Vorhersage gelernt und die Zwischenrepräsentation zur Speicherung/Kompression 120 der Daten und zum Monitoring und Klassierung verwendet.

Ferner können gemäß dem beispielhaften Verfahren 100 manuell definierte Merkmale aus Elektro- oder Photolumineszenz-Messungen von Solarzellen verwendet werden, um etwa Prozessfehler zu detektieren. Diese sind z.B. Fingerunterbrechungen, Risse, Kristallbaufehler etc.

Beispielsweise werden dazu neuronale Netzwerke, faltende neuronale Netze oder Deep-Learning-Verfahren verwendet. Deep-Learning Verfahren sind maschinelle Lernverfahren, die eine Ende-zu-Ende Verknüpfung zwischen Eingabedaten wie Bildern und Ausgabedaten wie z.B. Qualitätsklassen oder Bildern, erzeugen. In der Regel wird das Netzwerk optimiert, so dass eine Verlustfunktion minimiert wird. Dies kann zum Beispiel die Zuweisung zu einer Klasse sein. Hierüber können auch Daten komprimiert werden, indem die Beschreibung der Struktur innerhalb des Netzwerkes encodiert wird, um daraufhin wieder dekodiert zu werden (Encoder-Decoder Architektur). Beim Autoencoder ist die Verlustfunktion hierbei häufig der Unterschied der rekonstruierten Daten zu den gemessenen Daten (Eingabebild). Jedoch können auch andere Bilder benutzt werden.

Ein faltendes neuronales Netzwerk lernt die Vorhersage eines Qualitätsparameters anhand eines oder mehrerer Eingabebilder. Im Training lernt es eine Vorhersage des Zielparameter anhand von paaren von Eingabedaten und realen Messungen des Zielparameters. Im Anwendungsfall (Test) wird das Netzwerk dazu genutzt um diese Parameter vorauszusagen. Hierbei werden die Qualitätsparameter nur noch zur Evaluation benötigt. Beim Durchlaufen des Netzwerkes werden die Eingabedaten schrittweise mehr und mehr komprimiert, so dass eine reduzierte, abstrakte und semantisch wertvolle Repräsentation der Daten entsteht. Diese Repräsentation kann aus dem Netzwerk für jede Probe erzeugt werden und aus dem Netzwerk ausgelesen werden.

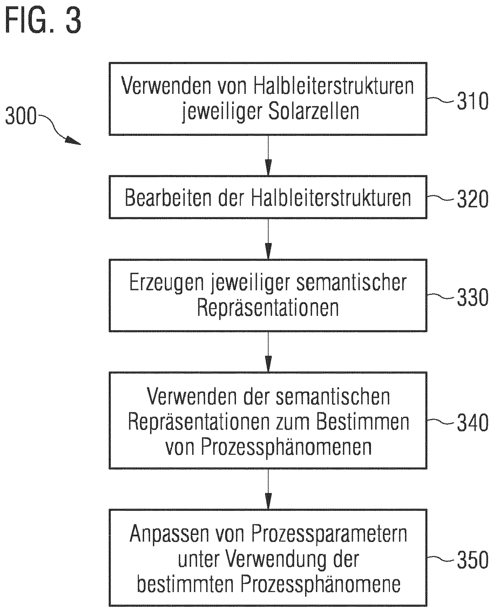

Die Repräsentation oder semantische Repräsentation besteht z.B. aus einem Merkmalsvektor oder mehrdimensionalen Merkmalskombination, das typischerweise am Ende eines Netzwerkes zur Klassifikation oder Regression entsteht. Beispielsweise entspricht eine Klassifikation einer Klassierung und eine Regression einer Vorhersage eines kontinuierlichen Wertes. Anhand des Merkmalsvektors findet dann die Vorhersage der Qualitätsparameter statt. Sie hat sowohl eine Aussagekraft bezüglich des Qualitätsparameter, weiterhin stellt sie eine Kompression der Strukturen im Bild dar. Die Aussagekraft kann erhöht werden, wenn weiterhin ortsaufgelöste Strukturen vorhergesagt werden (Fig.3). Bei Encoder-Decoder Architekturen wird die semantische Repräsentation im Bereich des "bottle-necks" etwa nach dem encoder oder am Ende des Netzes nach dem Decoder entnommen. Die Repräsentation kann aber auch eine Kombination unterschiedlicher Merkmale des Netzwerkes sein.

Ein Aspekt der Erfindung ist es, dass man eine abstrakte Repräsentation der Daten dazu verwendet die Daten komprimiert zu speichern 120. Weiterhin werden die Bilder anhand der komprimierten Repräsentation vergleichbar. Je nach Eingabedaten und Ausgabedaten kann man daraufhin die Kristallisation analysieren, Prozesse vergleichen / überwachen, Material und Prozesseigenschaften trennen und die Daten klassieren.

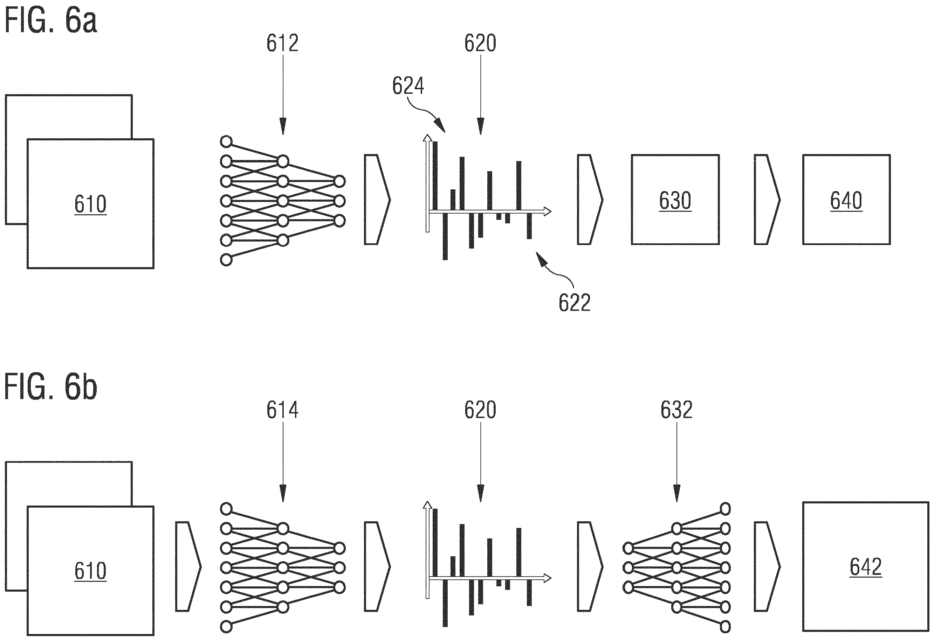

Es gibt zahlreiche Architekturen von faltenden neuronalen Netzen. Architekturen können darüber unterschieden werden, ob sie ortsaufgelöste Qualitätsdaten vorhersagen (vgl. Fig. 6b) oder einen oder eine Gruppe unterschiedlicher Parameter vorhersagen (Klassifikations- oder Regressionsmodelle) (vgl. Fig. 6a). Im Wesentlichen bestehen die hier adressierten Modelle aus Faltungsschichten (Convolutional layer), nicht linearen Einheiten, wie der Re-LU (Rectifiying Linear Unit), und Pooling-Schichten zum downsamplen. Optional können Schichten zum Upsampling, Normalisierungsschritte und Split- und Skip-connections und ähnliche Schichten Teil des Netzwerkes sein. Beim Training können Verfahren zur Datenaugmentierung, wie zum Beispiel Koordinaten-Transformationen, zufälligem Abschneiden des Randes oder Rauschen, zu einer Erweiterung des Datensatzes und Erhöhung der Robustheit des Modells verwendet werden. Mittels sogenannten Dropout-Schichten kann die Robustheit des Modells beim Training weiterhin erhöht werden. Diese Schichten können auf unterschiedlichste Art kombiniert werden.

Fig. 2 zeigt ein Flussdiagramm eines Verfahrens 200 zum Bestimmen einer Eigenschaft einer Solarzelle. Das Verfahren 200 umfasst ein Verwenden 210 einer semantischen Repräsentation einer mittels eines bildgebenden Verfahrens erzeugten Abbildung der Solarzelle, wobei die semantische Repräsentation mittels eines neuronalen Netzes erzeugt ist, und ferner ein Bestimmen 220 der zumindest einen Eigenschaft der Solarzelle basierend auf der semantischen Repräsentation.

Fig. 3 zeigt ein Flussdiagramm eines Verfahrens 300 zum Verbessern eines Halbleiterprozesses. Es umfasst ein Verwenden 310 von Halbleiterstrukturen jeweiliger Solarzellen, ein Bearbeiten 320 der Halbleiterstrukturen in einem Halbleiterprozess mit vorbestimmten Prozessparametern, ein Erzeugen 330 jeweiliger, den Halbleiterstrukturen zugeordneten semantischen Repräsentationen von Abbildungen umfassend die jeweilige Halbleiterstruktur, ein Verwenden 340 der semantischen Repräsentationen in Verbindung mit den vorbestimmten Prozessparametern, zum Bestimmen von Prozessphänomenen und ein Anpassen 350 der Prozessparameter unter Verwendung der zuvor bestimmten Prozessphänomene.

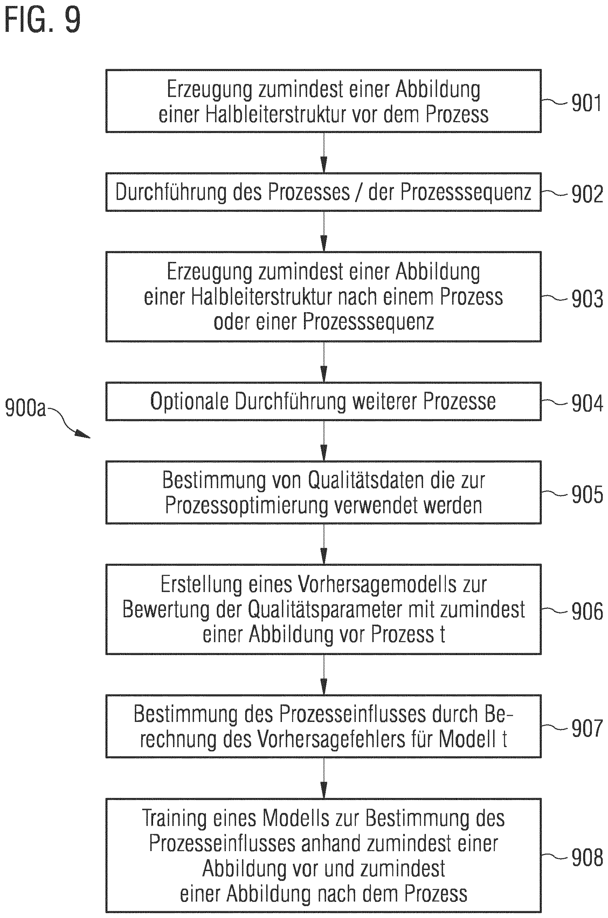

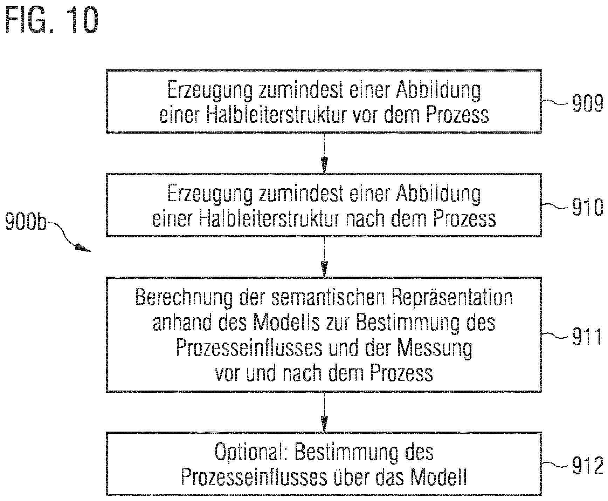

Weitere Beispiele und detaillierte Ausführungen des Verfahrens 100, des Verfahrens 200 und/oder des Verfahrens 300 sind auch in Verbindung mit Fig. 9 und Fig. 10 gegeben.

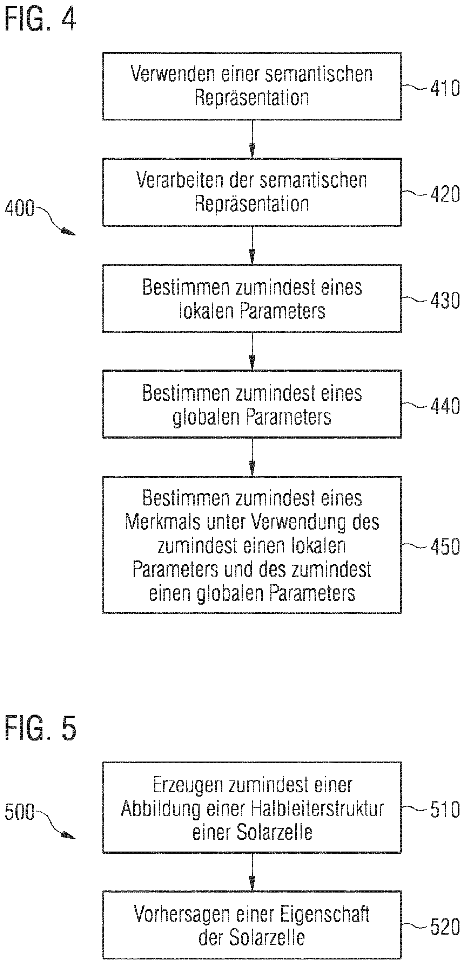

Fig. 4 zeigt ein Flussdiagramm eines Verfahrens 400 zur Bewertung ortsaufgelöster Qualitätsbilder. Das Verfahren 400 umfasst ein Verwenden 410 einer semantischen Repräsentation des Qualitätsbildes der Halbleiterstruktur, ein Verarbeiten 420 der semantischen Repräsentation in einem neuronalen Netzwerk, um eine erste und eine zweite Signalausgabe zu erzeugen, ein Bestimmen 430 zumindest eines lokalen Parameters durch Auswerten der ersten Signalausgabe umfassend Informationen von nicht-abgeschatteten Bereichen der Halbleiterstruktur, ein Bestimmen 440 zumindest eines globalen Parameters durch Auswerten der zweiten Signalausgabe umfassend Informationen der gesamten Halbleiterstruktur und ein Bestimmen 450 zumindest eines Merkmals eines abgeschatteten Bereiches unter Verwendung des zumindest einen lokalen Parameters und des zumindest einen globalen Parameters.

Fig. 5 zeigt ein Flussdiagramm eines Verfahrens 500 zum Vorhersagen einer Eigenschaft einer Solarzelle. Das Verfahren 500 umfasst ein Erzeugen 510 zumindest einer Abbildung einer Halbleiterstruktur der Solarzelle mittels eines bildgebenden Verfahrens nach einem oder verschiedenen Prozessschritten während der Herstellung der Solarzelle, wobei die Abbildung zumindest Informationen bezüglich rekombinationsaktiver Defekte der Halbleiterstruktur, bezüglich Prozessfehlern bei der Herstellung, bezüglich Stromeinträgen der Solarzelle bei unterschiedlichen Anregungsbedingungen oder bezüglich einem Serienwiderstand der Solarzelle umfasst und ein Vorhersagen 520 der Eigenschaft mittels eines unter Verwendung von Messergebnissen kontaktierter Eigenschaftsmessungen trainierten neuronalen Netzes, um mittels kontaktloser Messungen die Eigenschaft der Solarzelle vorherzusagen.

Fig. 6a-c zeigen Architekturen von neuronalen Netzen mit semantischen Repräsentationen. Die gezeigten Architekturen können zum Verarbeiten von Abbildungen 610 von Halbleiterstrukturen verwendet werden. Gemäß dem Beispiel aus Fig. 6a wird eine Abbildung 610 in einen Eingang eines neuronales Netzes 612 eingegeben, um eine semantische Repräsentation 620 zu erzeugen. Die semantische Repräsentation 620 kann verschiedene Merkmale 622 sowie Aktivierungszustände 624 der jeweiligen Merkmale aufweisen. Die semantische Repräsentation 620 kann unter Verwendung eines Regressions- oder Klassifizierungs-Modells 630 verarbeitet werden, um Ausgabeparameter 640, zum Beispiel IV-Parameter oder eine IV-Klasse einer Solarzelle, zu erzeugen.

Gemäß Fig. 6b wird zum Verarbeiten der Abbildung 610 zur Repräsentation 620 ein CNN (CNN: convolutional neural network; dtsch. faltendes neuronales Netzwerk)-Encoder 614 verwendet. Die semantische Repräsentation 620 kann in einem CNN-Decoder 632 zu Ausgangsdaten 642, die beispielsweise ortsaufgelöste Qualitätsdaten vorhersagen, verarbeitet werden.

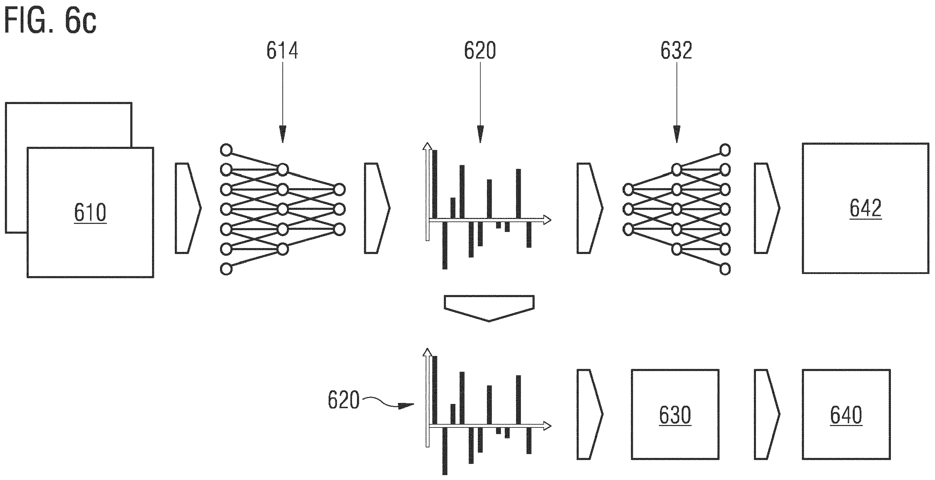

Fig. 6c zeigt eine Architektur eines gemischten Modells umfassend CNN-Encoder 614, CNN-Decoder 632 und das Regressionsmodell 630. Mit dem gemischten Modell gemäß Figur 6c ist es möglich, sowohl ortsaufgelöste Qualitätsdaten 642 als auch einzelne Parameter 640 oder eine Gruppe von Parametern 640 (zum Beispiel IV-Parameter) vorherzusagen.

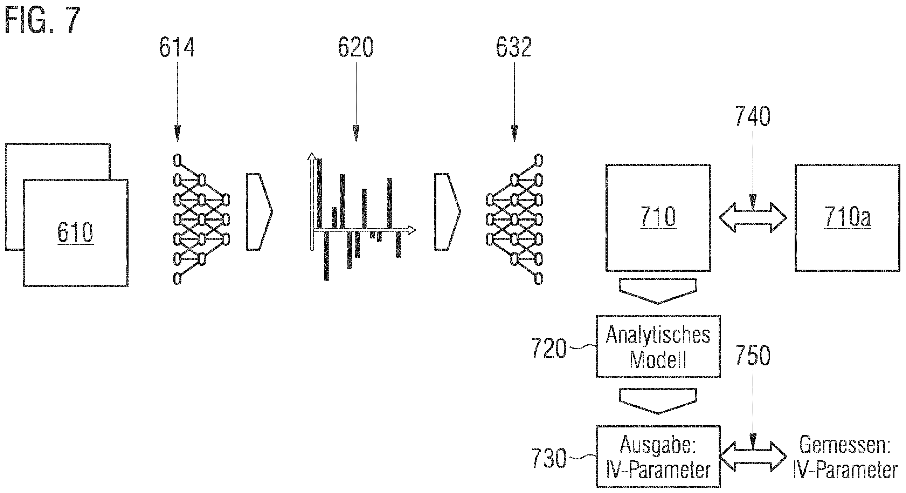

Fig. 7 zeigt eine schematische Darstellung eines Verfahrens zur Kalibrierung ortsaufgelöster Qualitätsmessungen. Das Verfahren basiert auf der Kombination globaler und lokaler Verlustfunktionen beim Netzwerktraining. In einem Netzwerk wird die ortsaufgelöste Vorhersage 710 eines Solarzellenparameters vorhergesagt. Aus den ortsaufgelösten Qualitätsparametern 710 kann anhand eines analytischen/empirischen Modells 720 ein Wert eines Parameters 730 aus der Strom-Spannungs-Kennlinie berechnet werden. Beim Training des Netzwerkes wird das Modell zur Vorhersage des ortsaufgelösten Parameters derart optimiert, dass sowohl die lokale Struktur der ortsaufgelösten Qualitätsparameters erhalten bleibt (Verlustfunktion 740), sowie der Vorhersagefehler des globalen Qualitätswertes minimiert wird (Verlustfunktion 750). Das Verfahren zur Kalibrierung kann in wesentlichen Punkten der Bewertung abgeschatteter Bereiche entsprechen.

Die Eingabe 610 sind gemäß dem Beispiel aus Fig. 7 Messungen an einer Solarzelle und/oder eines Solarzellenvorläufers, wie der Elektrolumineszenz-Aufnahme und/oder einer Photolumineszenz-Aufnahme der Solarzelle. In diesen sind Serienwiderstandseffekte sichtbar, können aber nicht ohne weiteres von anderen Defekten, wie Rekombinationsdefekten, unterschieden werden. Das Netz soll das Bild des Serienwiderstandes vorhersagen. Für das Netzwerktraining wurden Messungen 710a der gleichen Probe bestimmt. Weiterhin kann über das analytische Modell der globale Serienwiderstand aus der der Solarzelle abgeleitet werden. Dieser wird aus der Strom-Spannungs-Kennlinie bestimmt. Der globale Serienwiderstand ist der Mittelwert über das Bild des Serienwiderstandes. Das Netz wird nun bezüglich der Vorhersage des Serienwiderstandbildes, sowie des globalen Serienwiderstandes optimiert. Analog kann aus den Eingabebildern 610 auch ein Modell für das Bild der Dunkelsättigungsstromdichte oder das Bild des Verhältnisses der globalen Kurzschlussstromdichte zum Bild der Dunkelsättigungsstromdichte vorhergesagt werden. Daraus kann über das analytische Modell entsprechend dem ein-dioden-Modell die Leerlaufspannung berechnet werden. Bei der Optimierung wird wiederum der Fehler der lokalen Vorhersage des Verhältnisses aus Kurzschlussstromdichte und Dunkelsättigungsstromdichte minimiert (Verlustfunktion 740), sowie der Fehler der globalen Leerlaufspannung der beispielsweise aus der Strom-Spannungskennlinie berechnet werden kann (Verlustfunktion 740).

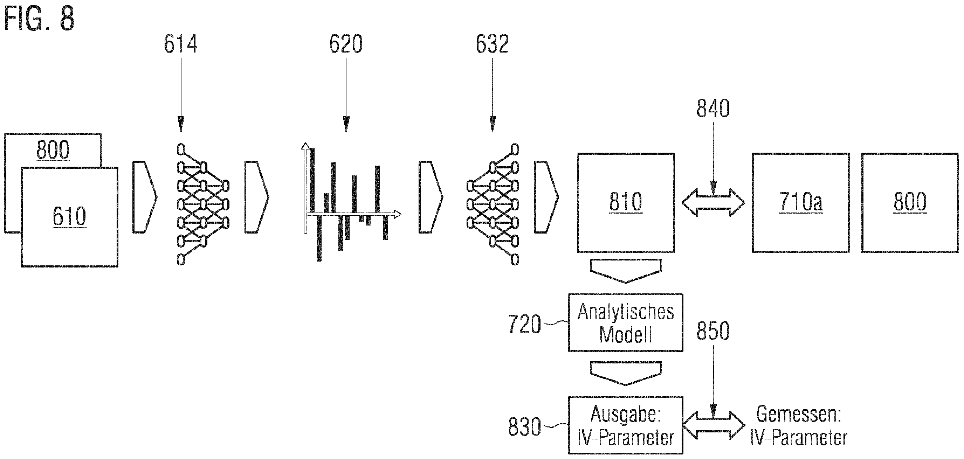

Fig. 8 zeigt eine schematische Darstellung eines Verfahrens zur Bewertung abgeschatteter Bereiche in ortsaufgelösten Qualitätsbildern. Das Verfahren basiert auf der Kombination globaler und lokaler Verlustfunktionen beim Netzwerktraining unter Berücksichtigung der abgeschatteten Bereiche. Bei Qualitätsmessungen können bestimmte Bereiche der Solarzelle, z.B. durch den Druckprozess, abgeschattet sein, wodurch sie nicht vermessen werden können. Eine Maske 800, die zur Abschattung führt, kann sowohl bei der Eingabe in das Netz 614 als auch beim Training zum Minimieren einer Verlustfunktion 840 berücksichtigt werden. Ziel des Verfahrens ist es, einen ortsaugelösten Wert für die abgeschatteten Bereiche zu ermitteln. Das Netzwerk besteht aus zwei Ausgaben 810, 830 (vgl. analog Fig. 7), wobei noch die Information über abgeschattete Bereiche in das Modell gegeben werden kann. Das Konzept ist nun, dass bei einer lokal aufgelösten Verlustfunktion 840 nur nichtabgeschattete Bereiche berücksichtigt werden. Eine Verlustfunktion 850 zur Vorhersage des globalen Parameters wird hingegen über das ganze Bild berechnet. Dies ist insbesondere dann interessant, wenn das Eingabebild im abgeschatteten Bereich Informationen enthält, da es vor der Abschattung aufgenommen wurde.

Eingabe des Netzes sind Photolumineszenz-Aufnahmen 610 am Wafer oder Lumineszenz-Messungen 610 der Solarzelle. Das Netzwerk wird dahingehend trainiert das Verhältnis aus Kurzschlussstromdichte und Dunkelsättigungsstromdichte vorherzusagen (Verlustfunktion 840) und über ein zusätzliches analytisches Modell die Leerlaufspannung (Verlustfunktion 850) vorherzusagen. In der Maske werden die Bereiche der Busbars und Finger der Solarzelle markiert, die in der optischen Messung nicht gemessen werden können. Diese werden bei der Verlustfunktion 840 nicht berücksichtigt und können so über die Verlustfunktion 850 optimiert werden.

Aus dem Modell kann die optimale Orientierung der Probe für die Solarzellenproduktion abgeleitet werden, da die Qualität unter der Metallisierung auch von der Materialqualität abhängen kann. Dies gilt für alle Vorhersagemodelle bei denen entweder die Maske mit eingegeben wird, oder die Rotation beim Training immer gleich ist. Somit wird ein Modell zur Vorhersage der Materialqualität beschrieben. Aus PL-Abbildung des Wafers und Informationen zur Maske kann z.B. die Leerlaufspannung bestimmt werden, wobei die Maske die Informationen über das Druckbild in das Modell gibt.

Fig. 9 zeigt ein Verfahren, beispielsweise ein erstes Teilverfahren 900a, zum Training eines Modells zur Bestimmung eines Prozesseinflusses.

Die gezeigten Schritte können insbesondere in einem vorbestimmten Verfahren angewendet werden, das ein Erzeugen einer weiteren Abbildung umfassend die Halbleiterstruktur nach dem Halbleiterprozess, ein Verwenden der weiteren Abbildung zum Erzeugen der semantischen Repräsentation, zusätzlich zum Verwenden der Abbildung und/oder ein Bestimmen von Parametern des Halbleiterprozesses unter Verwendung der semantischen Repräsentation umfasst.

Das vorbestimmte Verfahren kann in einem ersten Teilverfahren ein benötigtes Vorhersagemodell zur Vorhersage des Qualitätsparameters bereitstellen. Insbesondere kann ein Vorhersagefehler (z.B. Prozessphänomene) relevant sein, der in einem zweiten Teilverfahren des vorbestimmten Verfahrens genutzt werden kann (vgl. Fig. 10). Im ersten Teilverfahren können Aufnahmen vor Prozess und Qualität nach Prozess verwendet werden. Die semantische Repräsentation wird hier z.B. nicht zwingend benötigt. Wesentliches Ergebnis können die Prozessphänomene sein. Beispielsweise entsprechen Vorhersagefehler Prozessphänomenen.

Beispielsweise umfasst das erste Teilverfahren eine Erzeugung 901 zumindest einer Abbildung einer Halbleiterstruktur vor dem Prozess; eine Durchführung 902 des Prozesses / der Prozesssequenz; eine Erzeugung 903 zumindest einer Abbildung einer Halbleiterstruktur nach einem Prozess oder einer Prozesssequenz; optional eine Durchführung 904 weiterer Prozesse; eine Bestimmung 905 von Qualitätsdaten die zur Prozessoptimierung verwendet werden; eine Erstellung 906 eines Vorhersagemodells zur Bewertung der Qualitätsparameters mit zumindest einer Abbildungen vor Prozess t; eine Bestimmung 907 des Prozesseinflusses durch Berechnung des Vorhersagefehlers für Modell t; und ein Training 908 eines Modells zur Bestimmung des Prozesseinflusses anhand zumindest einer Abbildung vor und zumindest einer Abbildung nach dem Prozess,

Des Weiteren kann ein Verfahren zur Vorhersage des Vorhersagefehlers (z.B. Prozesseinfluss) aus dem ersten Teilverfahren 900a bereitgestellt werden. Dieses Modell arbeitet z.B. mit Bildern vor und nach dem Prozess. Die semantische Repräsentation kann dann zur Analyse benutzt werden kann. Beispielsweise entsprechen Prozessphänomene Parametern des Halbleiterprozesses.

Fig. 10 zeigt ein entsprechendes zweites Teilverfahren 900b zur Bestimmung und/oder Analyse des Prozesseinflusses. Das zweite Teilverfahren 900b umfasst eine Erzeugung 909 zumindest einer Abbildung einer Halbleiterstruktur vor dem Prozess; eine Erzeugung 910 zumindest einer Abbildung einer Halbleiterstruktur nach dem Prozess; eine Berechnung 911 der semantischen Repräsentation anhand des Modells zur Bestimmung des Prozesseinflusses und der Messung vor und nach dem Prozess; und optional eine Bestimmung 912 des Prozesseinflusses über das Model.

Das erste und zweite Teilverfahren 900a, 900b kann insbesondere im Zusammenhang mit Verfahren 100 zum Verarbeiten von unter Verwendung von bildgebenden Verfahren erzeugten Abbildungen einer Halbleiterstruktur einer Solarzelle ferner umfassend ein Bearbeiten der Halbleiterstruktur in einem Halbleiterprozess ganz oder teilweise (einzelne Verfahrensschritte), im Zusammenhang mit Verfahren 200 und/oder im Zusammenhang mit Verfahren 300 zum Verbessern eines Halbleiterprozesses erfolgen. Im Allgemeinen können einzelne Schritte von Verfahren, die rein beispielhaft einem bestimmten Verfahren zugeordnet sind ebenso auch in anderen der gezeigten Verfahren angewendet werden, etwa um diese Verfahren weiter zu verbessern.

In weiteren Beispielen sind weitere Aspekte oder Weiterbildungen der Erfindung beschrieben, die z.B. in Kombination mit zuvor beschriebenen Aspekten zu Vorteilen führen können.

Ein Beispiel betrifft die Solarzellenkontrolle und ein entsprechendes Verfahren zum Vorhersagen der Strom-Spannungsparameter (IV-Parameter). Gemäß dem Beispiel des Verfahrens wird ein Vorhersagemodell mittels eines faltenden neuronalen Netzwerks trainiert, das optimiert wurde, um aus bildgebenden und parametrischen Daten, die während der Materialeingangskontrolle, Solarzellenproduktion und Solarzellenkontrolle an der Probe erhoben wurden, ein oder mehrere IV-Parameter vorhersagen (z.B. auch den Serienwiderstand), und aus dem Modell eine semantische Repräsentation des Netzwerkes abgeleitet werden kann. Die bildgebenden Messungen können hierbei zu einer Matrix mit unterschiedlichen Kanälen kombiniert werden, und/oder in verschiedene Teilnetze eingegeben werden und später kombiniert.

Bei dem Beispiel des Verfahrens kann die semantische Repräsentation zur effizienten Speicherung der Eingabedaten verwendet werden. Die Eingabedaten können hierbei aus beliebigen Kombinationen bildgebender Messungen, wie .z.B. Photolumineszenz, Elektrolumineszenz, Temperaturaufnahmen an Solarzellen, sowie Messungen am Wafer bestehen.

Beispielsweise wird eine Proben-Repräsentation erzeugt, die Teile der semantische Repräsentation enthält und anhand derer die Proben hinsichtlich Prozess und Material analysiert werden. Hierbei kann die Proben-Repräsentation auch IV-Werte enthalten und/oder hinsichtlich dieser analysiert werden. So können mittels maschineller Lernverfahren, wie z.B. Clustering-, Regressions- oder Klassifikationsverfahren, typische Defektphänomene und Prozessfehler identifiziert werden. Zur Identifikation von Phänomenen können die Proben hinsichtlich typischer Datenverteilungen der Proben-Repräsentation in Gruppen eingeteilt werden, mittels derer die Probe klassiert werden kann. Dies kann unüberwacht erfolgen (unüberwachtes Lernen des neuronalen Netzes), z.B. anhand der Verteilung der Daten, und/oder überwacht (überwachtes Lernen des neuronalen Netzes), anhand weiterer Qualitätsdaten, wie den IV-Daten oder annotierter Defektklassen, geschehen. Des Weiteren können darüber Aufschluss über Material-, Prozess- und Messfehler, wie etwa Kontaktierungsfehlern, gewonnen werden. Prototypen dieser "Phänomen-Klassen" können visualisiert werden und eine Defektursache zugewiesen werden.

Es kann eine Fehler-Detektierung bereitgestellt werden (Fault-Detektion), bspw. mittels eines Fehlerinformationssignals. Die Abweichung der Wirkungsgrade trotz ähnlicher Proben-Repräsentationen weist z.B. auf eine Anomalie in der Probe oder einen Prozessfehler hin. Ferner ist eine Analyse der Prozessentwicklung über den Vergleich der gemessenen Wirkungsgrade für ähnliche Beschreibungen möglich, die die semantische Repräsentation enthalten.

Ein Beispiel eines Verfahrens betrifft die Vorhersage von Solarzellenparametern ohne kontaktierte Messungen. Es ist es vor allem von Vorteil, wenn keine Messsysteme verwendet werden, die eine zeitaufwendige Kontaktierung der Solarzelle benötigen. Eingabeparameter können sein: Messung zur Identifikation von rekombinationsaktiven Defekte, wie der PL-Aufnahme am Wafer, der Solarzelle oder dem Solarzellenvorläufer; Messung zur Identifikation von Prozessfehlern an der Solarzelle oder des Solarzellenvorläufers, wie der PL-Aufnahme in verschiedenen Prozessschritten, der IR-Durchlichtmessung am Wafer; Messung zur Bestimmung des Stromeinträge, wie PL-Aufnahmen an der Solarzelle bei unterschiedlichen Anregungsbedingungen (SunsPL); und/oder Messung zur Bestimmung der Serienwiderstände wie der teilabgeschattete PL-Aufnahme an der Solarzelle. Ferner ist eine Messung zur Bestimmung der quasi statischen Fotoleitfähigkeit möglich. Ausgabeparameter können sein: Für die Sortierung der Solarzelle relevante Parameter, vor allem Kurzschlussstromdichte J_{sc}, Wirkungsgrad, und Leerlaufspannung V_{oc}, oder Qualitätsklasse, die aus den IV-Parametern abgleitet werden.

Es ist möglich, noch weitere Messungen zu ergänzen oder Messungen wegzulassen. Beispielsweise kann eine Farbmessung zur Klassierung integriert werden.

Ein Beispiel betrifft ein Verfahren, bei dem das faltende Neuronale Netz weiterhin zur Vorhersage ortsaufgelöster Qualitätskriterien, wie dem Bild des Serienwiderstandes oder dem Bild des Dunkelsättigungsstromes optimiert wird. Die semantische Repräsentation kann hierbei eine Mischung aus Merkmalen sein, die zum einen zur Vorhersage des einen Bildes und zur Vorhersage des anderen Bildes genutzt wird und in unterschiedlicher Kombination zur Vorhersage bestimmter IV Parameter.

Beispielsweise wird ein Verfahren bereitgestellt, bei dem die daraus entstandene semantische Repräsentation in eine Proben-Repräsentation einfließt und darüber eine Optimierung der Prozessparameter erfolgt. Hierbei erfolgt die Optimierung über eine Parametrisierung anhand der entstandenen Repräsentation.

Ein Beispiel betrifft ein Verfahren, beispielsweise ein Verfahren zur Material- und Kristallisationsbewertung, bei dem das faltende neuronale Netz zur Vorhersage der IV-Parameter oder daraus abgeleitete Qualitätsklassen trainiert wird, wobei Messungen verwendet werden, die nach der Kristallisation am Brick oder/und nach dem Wafering am Wafer erhoben werden. Hierunter können unter anderem Messungen fallen, die eine Analyse der Komverteilung ermöglichen, wie etwa Auflichtmessung, Infrarotdurchlichtmessungen, Messungen zur Bestimmung der Rekombinationsaktivität/Lebensdauer der Ladungsträger, wie die Photolumineszenzmessung am Wafer und am Brick oder die Messung der Photoleitfähigkeit, Messungen zur Identifikation von Einschlüssen, wie durch Infrarot (IR)-Durchlicht-Verfahren an Wafern, sowie der Widerstand, der an Wafer und Brick gemessen werden kann. Z.B. können Silizium Carbid Einschlüsse über das Transmissionssignal - am Brick oder das Transmissionssignal am Wafer ortsaufgelöst gemessen werden.

Ein Beispiel betrifft ferner ein Verfahren, bei dem die daraus entstandene semantische Repräsentation in eine Proben-Repräsentation einfließt und, z.B. analog einem zuvor beschriebenen Verfahren, zur Bewertung der Kristallisation eingesetzt wird. Die Proben-Repräsentation ermöglicht einen Vergleich der Proben. Zur Analyse können beispielsweise Si-Wafer bezüglich bestimmter Kristallisationskriterien, wie Brick-Herkunft, Art des verwendeten Feedstock, Rezeptur der Kristallisation oder des Seedingverfahrens voneinander unterschieden werden und die Proben hinsichtlich der Homogenität innerhalb einer dieser Gruppe oder die Ähnlichkeit zwischen den Kategorien mittels der Proben-Repräsentation verglichen werden. Zur Analyse können überwachte und unüberwachte Lernverfahren eingesetzt werden.

Ein Beispiel betrifft ferner ein Verfahren, bei dem Anomalien und Verbesserungen des Solarzellenprozesses darüber festgestellt werden, dass die vorhergesagte Solarzellenqualität nicht der erwarteten Solarzellenqualität entspricht, bzw. das Proben mit gleicher Repräsentation zu abweichenden Solarzellenergebnissen führen.

Ein Beispiel betrifft ferner ein Verfahren, bei dem das faltende Neuronale Netz weiterhin zur Vorhersage ortsaufgelöster Qualitätskriterien, wie dem Bild des Serienwiderstandes oder dem Bild des Dunkelsättigungsstromes optimiert wird.

Ein Beispiel betrifft die Charakterisierung eines Prozesses. Bei einer Analyse des Prozesses oder Halbleiterprozesses kann ein Raum oder Merkmalsraum der semantischen Repräsentation genutzt werden, um ähnliche Phänomene zu identifizieren. Beispielsweise können Datenanalyse-Verfahren (zum Beispiel Clustering) verwendet werden, um unbekannte Zusammenhänge in den Daten zu identifizieren. Diese Informationen übersteigen insbesondere den Informationsgehalt reiner IV-Messungen. Je nach Art der Analyse können unterschiedliche Phänomene identifiziert werden. Bei der Kristallisationsanalyse können beispielsweise unterschiedliche Materialdefekte identifiziert werden. Bei der Charakterisierung der Solarzelle können beispielsweise Material und/oder Prozesseigenschaften identifiziert werden.

Ein Beispiel betrifft die Optimierung eines Halbleiterprozesses. Bei einer Prozessoptimierung können jeweils semantische Repräsentationen und daraus abgeleitete Abstände zwischen den Repräsentationen in Zusammenhang oder Kombination mit zusätzlichen Informationen berücksichtigt werden. Zusätzliche Informationen können Prozessparameter oder weitere Informationen berücksichtigen, wie zum Beispiel die Position der Probe oder der Halbleiterstruktur im Brick bei einer Optimierung eines Kristallisationsprozesses; oder eine Position einer Solarzelle in einem Träger oder Carrier abhängig von einer Prozesszeit und/oder von Prozessparametern.

Zusammenfassend werden durch die vorliegende Erfindung Verfahren bereitgestellt, die eine semantische Repräsentation nutzen. Diese kann ein effizientes Speichern oder Analysieren von Parametern ermöglichen, beispielsweise durch Analyse der semantischen Repräsentation oder Vergleich der semantischen Repräsentation mit einer oder mehreren anderen semantischen Repräsentationen.

Die Aspekte und Merkmale, die zusammen mit einem oder mehreren der vorher detaillierten Beispiele und Figuren beschrieben sind, können auch mit einem oder mehreren der anderen Beispiele kombiniert werden, um ein gleiches Merkmal des anderen Beispiels zu ersetzen oder um das Merkmal in das andere Beispiel zusätzlich einzuführen.

Beispiele können weiterhin ein Computerprogramm mit einem Programmcode zum Ausführen eines oder mehrerer der obigen Verfahren sein oder sich darauf beziehen, wenn das Computerprogramm auf einem Computer oder Prozessor ausgeführt wird. Schritte, Operationen oder Prozesse von verschiedenen, oben beschriebenen Verfahren können durch programmierte Computer oder Prozessoren ausgeführt werden. Beispiele können auch Programmspeichervorrichtungen, z. B. Digitaldatenspeichermedien, abdecken, die maschinen-, prozessor- oder computerlesbar sind und maschinenausführbare, prozessorausführbare oder computerausführbare Programme von Anweisungen codieren. Die Anweisungen führen einige oder alle der Schritte der oben beschriebenen Verfahren aus oder verursachen deren Ausführung. Die Programmspeichervorrichtungen können z. B. Digitalspeicher, magnetische Speichermedien wie beispielsweise Magnetplatten und Magnetbänder, Festplattenlaufwerke oder optisch lesbare Digitaldatenspeichermedien umfassen oder sein. Weitere Beispiele können auch Computer, Prozessoren oder Steuereinheiten, die zum Ausführen der Schritte der oben beschriebenen Verfahren programmiert sind, oder (feld-)programmierbare Logik-Arrays ((F)PLAs = (Field) Programmable Logic Arrays) oder (feld-)programmierbare Gate-Arrays ((F)PGA = (Field) Programmable Gate Arrays), die zum Ausführen der Schritte der oben beschriebenen Verfahren programmiert sind, abdecken.

Durch die Beschreibung und Zeichnungen werden nur die Grundsätze der Offenbarung dargestellt. Weiterhin sollen alle hier aufgeführten Beispiele grundsätzlich ausdrücklich nur illustrativen Zwecken dienen, um den Leser beim Verständnis der Grundsätze der Offenbarung und der durch den (die) Erfinder beigetragenen Konzepte zur Weiterentwicklung der Technik zu unterstützen. Alle hiesigen Aussagen über Grundsätze, Aspekte und Beispiele der Offenbarung sowie konkrete Beispiele derselben umfassen deren Entsprechungen.

Ein als "Mittel zum..." Ausführen einer bestimmten Funktion bezeichneter Funktionsblock kann sich auf eine Schaltung beziehen, die ausgebildet ist zum Ausführen einer bestimmten Funktion. Somit kann ein "Mittel für etwas" als ein "Mittel ausgebildet für oder geeignet für etwas" implementiert sein, z. B. ein Bauelement oder eine Schaltung ausgebildet für oder geeignet für die jeweilige Aufgabe.

Funktionen verschiedener in den Figuren gezeigter Elemente einschließlich jeder als "Mittel", "Mittel zum Bereitstellen eines Signals", "Mittel zum Erzeugen eines Signals", etc. bezeichneter Funktionsblöcke kann in Form dedizierter Hardware, z. B "eines Signalanbieters", "einer Signalverarbeitungseinheit", "eines Prozessors", "einer Steuerung" etc. sowie als Hardware fähig zum Ausführen von Software in Verbindung mit zugehöriger Software implementiert sein. Bei Bereitstellung durch einen Prozessor können die Funktionen durch einen einzelnen dedizierten Prozessor, durch einen einzelnen gemeinschaftlich verwendeten Prozessor oder durch eine Mehrzahl von individuellen Prozessoren bereitgestellt sein, von denen einige oder von denen alle gemeinschaftlich verwendet werden können. Allerdings ist der Begriff "Prozessor" oder "Steuerung" bei Weitem nicht auf ausschließlich zur Ausführung von Software fähige Hardware begrenzt, sondern kann Digitalsignalprozessor-Hardware (DSP-Hardware; DSP = Digital Signal Processor), Netzprozessor, anwendungsspezifische integrierte Schaltung (ASIC = Application Specific Integrated Circuit), feldprogrammierbare Logikanordnung (FPGA = Field Programmable Gate Array), Nurlesespeicher (ROM = Read Only Memory) zum Speichern von Software, Direktzugriffsspeicher (RAM = Random Access Memory) und nichtflüchtige Speichervorrichtung (storage) umfassen. Sonstige Hardware, herkömmliche und/oder kundenspezifische, kann auch eingeschlossen sein.

Ein Blockdiagramm kann zum Beispiel ein grobes Schaltdiagramm darstellen, das die Grundsätze der Offenbarung implementiert. Auf ähnliche Weise können ein Flussdiagramm, ein Ablaufdiagramm, ein Zustandsübergangsdiagramm, ein Pseudocode und dergleichen verschiedene Prozesse, Operationen oder Schritte repräsentieren, die zum Beispiel im Wesentlichen in computerlesbarem Medium dargestellt und so durch einen Computer oder Prozessor ausgeführt werden, ungeachtet dessen, ob ein solcher Computer oder Prozessor explizit gezeigt ist. In der Beschreibung oder in den Patentansprüchen offenbarte Verfahren können durch ein Bauelement implementiert werden, das ein Mittel zum Ausführen eines jeden der jeweiligen Schritte dieser Verfahren aufweist.

Es versteht sich, dass die Offenbarung mehrerer, in der Beschreibung oder den Ansprüchen offenbarter Schritte, Prozesse, Operationen oder Funktionen nicht als in der bestimmten Reihenfolge befindlich ausgelegt werden soll, sofern dies nicht explizit oder implizit anderweitig, z. B. aus technischen Gründen, angegeben ist. Daher werden diese durch die Offenbarung von mehreren Schritten oder Funktionen nicht auf eine bestimmte Reihenfolge begrenzt, es sei denn, dass diese Schritte oder Funktionen aus technischen Gründen nicht austauschbar sind. Ferner kann bei einigen Beispielen ein einzelner Schritt, Funktion, Prozess oder Operation mehrere Teilschritte, -funktionen, -prozesse oder -operationen einschließen und/oder in dieselben aufgebrochen werden. Solche Teilschritte können eingeschlossen sein und Teil der Offenbarung dieses Einzelschritts sein, sofern sie nicht explizit ausgeschlossen sind.

## Patentansprüche

1. Verfahren (100) zum Verarbeiten von unter Verwendung von bildgebenden Verfahren erzeugten Abbildungen (610) einer Halbleiterstruktur einer Solarzelle, das Verfahren (100) umfassend
Verarbeiten (110) der Abbildung (610) der Halbleiterstruktur mittels eines trainierten neuronalen Netzes, um eine semantische Repräsentation (620) der Abbildung (610) zu erzeugen, wobei eine Datengröße der semantischen Repräsentation (620) geringer ist, als eine Datengröße der in den Eingang des neuronalen Netzes eingegebenen Abbildung (610); und
Speichern (120) der semantischen Repräsentation (620) zugeordnet zur Halbleiterstruktur, als Informationsträger von relevanten Informationen der Abbildung (610) für ein Bestimmen einer Eigenschaft der Solarzelle und/oder für eine Kristallanalyse einer Halbleiterstruktur der Solarzelle, wobei durch das Erzeugen der semantischen Repräsentation (620) ein komprimiertes Speichern (120) von Informationen der Abbildung (610) ermöglicht wird.

2. Verfahren (100) gemäß Anspruch 1,
wobei die semantische Repräsentation (620) auf zumindest zwei mittels des neuronalen Netzes verarbeiteten Abbildungen (610) der Halbleiterstruktur der Solarzelle basiert, die mittels unterschiedlicher bildgebender Verfahren erzeugt sind.

3. Verfahren (200) zum Bestimmen zumindest einer Eigenschaft einer Solarzelle, das Verfahren umfassend:
Verwenden (210) einer gemäß Anspruch 1 oder 2 erzeugten semantischen Repräsentation (620) einer mittels eines bildgebenden Verfahrens erzeugten Abbildung (610) der Solarzelle, wobei die semantische Repräsentation (620) mittels eines neuronalen Netzes erzeugt ist; und
Bestimmen (220) der zumindest einen Eigenschaft der Solarzelle basierend auf der semantischen Repräsentation (620).

4. Verfahren (200) gemäß Anspruch 3,
wobei die Eigenschaft unter Verwendung eines neuronalen Netzes bestimmt wird.

5. Verfahren (200) gemäß Anspruch 3 oder 4,
wobei die zumindest eine Eigenschaft eine Leerlaufspannung, einen Kurzschlussstrom, eine Kurzschlussstromdichte, einen Wirkungsgrad, einen Füllfaktor und/oder einen Serienwiderstand der Solarzelle umfasst.

6. Verfahren (200) gemäß einem der vorhergehenden Ansprüche 3 bis 5,
wobei die zumindest eine Eigenschaft ein ortsaufgelöstes Qualitätskriterium der Solarzelle betrifft.

7. Verfahren (200) gemäß einem der vorhergehenden Ansprüche 3 bis 6, ferner umfassend Zuordnen der Solarzelle zu einer Qualitätsklasse basierend auf der zumindest einen Eigenschaft.

8. Verfahren (200) gemäß einem der vorhergehenden Ansprüche,
wobei die semantische Repräsentation (620) eine Gewichtsverteilung von Gewichten einer Schicht des neuronales Netzes umfasst.

9. Verfahren (200) gemäß einem der vorhergehenden Ansprüche,
wobei die Abbildung (610), auf der die semantische Repräsentation (620) basiert, unter Verwendung von Elektrolumineszenz, Photolumineszenz, oder Temperaturaufnahmen erstellt ist.

10. Verfahren (200) gemäß einem der vorhergehenden Ansprüche, umfassend
Verwenden der semantischen Repräsentation (620) zum Vergleich der Halbleiterstruktur mit einer anderen Halbleiterstruktur unter Verwendung einer zur anderen Halbleiterstruktur korrespondierenden semantischen Repräsentation zum Ermitteln von Informationen der Halbleiterstrukturen und/oder eines Halbleiterprozesses zum Bearbeiten der Halbleiterstrukturen.

11. Verfahren (200) gemäß einem der vorhergehenden Ansprüche, ferner umfassend Bearbeiten der Halbleiterstruktur in einem Halbleiterprozess;
Erzeugen einer weiteren Abbildung umfassend die Halbleiterstruktur nach dem Halbleiterprozess;
Verwenden der weiteren Abbildung zum Erzeugen der semantischen Repräsentation (620), zusätzlich zum Verwenden der Abbildung (610); und
Bestimmen von Parametern des Halbleiterprozesses unter Verwendung der semantischen Repräsentation (620).

12. Verfahren (300) zum Verbessern eines Halbleiterprozesses, das Verfahren umfassend:
Verwenden (310) von Halbleiterstrukturen jeweiliger Solarzellen;
Bearbeiten (320) der Halbleiterstrukturen in einem Halbleiterprozess mit vorbestimmten Prozessparametern;
Erzeugen (330) jeweiliger, den Halbleiterstrukturen zugeordneten semantischen Repräsentationen (620) von Abbildungen (610) umfassend die jeweilige Halbleiterstruktur,
wobei die semantischen Repräsentationen (620) gemäß einem von Anspruch 1 oder 2 erzeugt werden;
Verwenden (340) der semantischen Repräsentationen (620) in Verbindung mit den vorbestimmten Prozessparametern, zum Bestimmen von Prozessphänomenen; und
Anpassen (350) der Prozessparameter unter Verwendung der zuvor bestimmten Prozessphänomene.

13. Verfahren (300) gemäß Anspruch 12, ferner umfassend:
Ausgeben einer Prozessfehlerinformation im Fall, dass nach einem Halbleiterprozess eine Abweichung einer Eigenschaft der Solarzelle von einer Standardeigenschaft auftritt, obwohl eine semantische Repräsentation (620), die auf einer vor dem Halbleiterprozess erzeugten Abbildung (610) der Halbleiterstruktur der Solarzelle basiert, einer Standard-Repräsentation entspricht.

14. Verfahren (400) zur Bewertung ortsaufgelöster Qualitätsbilder (610) von Halbleiterstrukturen, das Verfahren umfassend:
Verwenden (410) einer gemäß Anspruch 1 oder 2 erzeugten semantischen Repräsentation (620) des Qualitätsbildes (610) der Halbleiterstruktur;
Verarbeiten (420) der semantischen Repräsentation (620) in einem neuronalen Netzwerk, um eine erste und eine zweite Signalausgabe zu erzeugen;
Bestimmen (430) zumindest eines lokalen Parameters durch Auswerten der ersten Signalausgabe umfassend Informationen von nicht-abgeschatteten Bereichen der Halbleiterstruktur;
Bestimmen (440) zumindest eines globalen Parameters durch Auswerten der zweiten Signalausgabe umfassend Informationen der gesamten Halbleiterstruktur; und
Bestimmen (450) zumindest eines Merkmals eines abgeschatteten Bereiches unter Verwendung des zumindest einen lokalen Parameters und des zumindest einen globalen Parameters.

15. Verfahren (500) gemäß einem der vorhergehenden Ansprüche, wobei das Verfahren zum Vorhersagen von zumindest einer Eigenschaft einer Solarzelle ferner umfasst:
Erzeugen (510) zumindest einer Abbildung (610) einer Halbleiterstruktur der Solarzelle mittels eines bildgebenden Verfahrens nach einem oder verschiedenen Prozessschritten während der Herstellung der Solarzelle, wobei die Abbildung (610) zumindest Informationen bezüglich rekombinationsaktiver Defekte der Halbleiterstruktur, bezüglich Prozessfehlern bei der Herstellung, bezüglich Stromeinträgen der Solarzelle bei unterschiedlichen Anregungsbedingungen oder bezüglich einem Serienwiderstand der Solarzelle umfasst; und
Vorhersagen (520) der Eigenschaft mittels eines unter Verwendung von Messergebnissen kontaktierter Eigenschaftsmessungen trainierten neuronalen Netzes, um mittels kontaktloser Messungen die Eigenschaft der Solarzelle vorherzusagen,
wobei die Eigenschaft zumindest eines aus einem Wirkungsgrad der Solarzelle, eines Kurzschlussstroms der Solarzelle, einer Leerlaufspannung der Solarzelle oder einem Füllfaktor der Solarzelle umfasst.

## Claims

1. A method (100) of processing images (610) of a semiconductor structure of a solar cell generated using imaging methods, the method (100) comprising
processing (110) the image (610) of the semiconductor structure by means of a trained neural network to generate a semantic representation (620) of the image (610), wherein a data size of the semantic representation (620) is smaller than a data size of the image (610) input to the input of the neural network; and
storing (120) the semantic representation (620) associated with the semiconductor structure as an information carrier of relevant information of the image (610) for determining a property of the solar cell and/or for a crystal analysis of a semiconductor structure of the solar cell, wherein generating the semantic representation (620) enables compressed storage (120) of information of the image (610).

2. The method (100) according to claim 1,
wherein the semantic representation (620) is based on at least two images (610) of the semiconductor structure of the solar cell processed by means of the neural network which are generated by means of different imaging methods.

3. A method (200) of determining at least one property of a solar cell, the method comprising:
using (210) a semantic representation (620), generated according to claim 1 or 2, of an image (610) of the solar cell generated by means of an imaging method, wherein the semantic representation (620) is generated by means of a neural network; and
determining (220) the at least one property of the solar cell based on the semantic representation (620).

4. The method (200) according to claim 3,
wherein the property is determined using a neural network.

5. The method (200) according to claim 3 or 4,
wherein the at least one property comprises an open-circuit voltage, a short-circuit current, a short-circuit current density, an efficiency, a fill factor and/or a series resistance of the solar cell.

6. The method (200) according to any one of the preceding claims 3 to 5,
wherein the at least one property relates to a space-resolved quality criterion of the solar cell.

7. The method (200) according to any one of the preceding claims 3 to 6, further comprising
assigning the solar cell to a quality class based on the at least one property.

8. The method (200) according to any one of the preceding claims,
wherein the semantic representation (620) comprises a weight distribution of weights of a layer of the neural network.

9. The method (200) according to any one of the preceding claims,
wherein the image (610) on which the semantic representation (620) is based is created using electroluminescence, photoluminescence, or temperature recordings.

10. The method (200) according to any one of the preceding claims, comprising
using the semantic representation (620) to compare the semiconductor structure with another semiconductor structure using a semantic representation corresponding to the other semiconductor structure to determine information of the semiconductor structures and/or a semiconductor process for processing the semiconductor structures.

11. The method (200) according to any one of the preceding claims, further comprising processing the semiconductor structure in a semiconductor process;
generating a further image comprising the semiconductor structure after the semiconductor process;
using the further image to generate the semantic representation (620) in addition to using the image (610); and
determining parameters of the semiconductor process using the semantic representation (620).

12. A method (300) of improving a semiconductor process, the method comprising:
using (310) semiconductor structures of respective solar cells;
processing (320) the semiconductor structures in a semiconductor process with predetermined process parameters;
generating (330) respective semantic representations (620) of images (610) associated with the semiconductor structures, comprising the respective semiconductor structure, wherein the semantic representations (620) are generated according to any one of claims 1 or 2;
using (340) the semantic representations (620) in conjunction with the predetermined process parameters to determine process phenomena; and
adjusting (350) the process parameters using the previously determined process phenomena.

13. The method (300) according to claim 12, further comprising:
outputting process error information in the event that a deviation of a property of the solar cell from a standard property occurs after a semiconductor process, although a semantic representation (620) based on an image (610) of the semiconductor structure of the solar cell generated before the semiconductor process corresponds to a standard representation.

14. A method (400) of evaluating space-resolved quality images (610) of semiconductor structures, the method comprising:
using (410) a semantic representation (620) of the quality image (610) of the semiconductor structure generated according to claim 1 or 2;
processing (420) the semantic representation (620) in a neural network to generate a first and a second signal output;
determining (430) at least one local parameter by evaluating the first signal output comprising information of unshaded areas of the semiconductor structure;
determining (440) at least one global parameter by evaluating the second signal output comprising information of the entire semiconductor structure; and
determining (450) at least one feature of a shaded area using the at least one local parameter and the at least one global parameter.

15. The method (500) according to any one of the preceding claims, the method of predicting at least one property of a solar cell further comprising:
generating (510) at least one image (610) of a semiconductor structure of the solar cell by means of an imaging method after one or various process steps during manufacturing of the solar cell, the image (610) comprising at least information relating to recombination-active defects of the semiconductor structure, relating to process errors during manufacturing, relating to current inputs of the solar cell under different excitation conditions or relating to a series resistance of the solar cell; and
predicting (520) the property by means of a neural network trained using measurement results of contacted property measurements to predict the property of the solar cell by means of non-contact measurements,
wherein the property comprises at least one of an efficiency of the solar cell, a short-circuit current of the solar cell, an open-circuit voltage of the solar cell or a fill factor of the solar cell.

## Revendications

1. Procédé (100) pour traiter des images (610) d'une structure de semi-conducteur d'une cellule solaire générées en utilisant des procédés d'imagerie, le procédé (100) comprenant le fait de
traiter (110) l'image (610) de la structure de semi-conducteur au moyen d'un réseau neuronal entraîné pour générer une représentation sémantique (620) de l'image (610), une taille de données de la représentation sémantique (620) étant inférieure à une taille de données de l'image (610) entrée dans l'entrée du réseau neuronal ; et
stocker (120) la représentation sémantique (620) associée à la structure de semi-conducteur en tant que support d'informations d'informations pertinentes de l'image (610) pour déterminer une propriété de la cellule solaire et/ou pour une analyse cristalline d'une structure de semi-conducteur de la cellule solaire, la génération de la représentation sémantique (620) permettant un stockage comprimé (120) d'informations de l'image (610).

2. Procédé (100) selon la revendication 1,
la représentation sémantique (620) étant basée sur au moins deux images (610) de la structure de semi-conducteur de la cellule solaire traitées au moyen du réseau neuronal qui sont générées au moyen de différents procédés d'imagerie.

3. Procédé (200) pour déterminer au moins une propriété d'une cellule solaire, le procédé comprenant le fait de :
utiliser (210) une représentation sémantique (620), générée selon la revendication 1 ou 2, d'une image (610) de la cellule solaire générée au moyen d'un procédé d'imagerie, la représentation sémantique (620) étant générée au moyen d'un réseau neuronal ; et
déterminer (220) l'au moins une propriété de la cellule solaire sur la base de la représentation sémantique (620).

4. Procédé (200) selon la revendication 3,
la propriété étant déterminée en utilisant un réseau neuronal.

5. Procédé (200) selon la revendication 3 ou 4,
l'au moins une propriété comprenant une tension à vide, un courant de court-circuit, une densité de courant de court-circuit, un rendement, un facteur de remplissage et/ou une résistance série de la cellule solaire.

6. Procédé (200) selon l'une des revendications précédentes 3 à 5,
l'au moins une propriété concernant un critère de qualité à résolution spatiale de la cellule solaire.

7. Procédé (200) selon l'une des revendications précédentes 3 à 6, comprenant en outre le fait de
associer la cellule solaire à une classe de qualité sur la base de l'au moins une propriété.

8. Procédé (200) selon l'une des revendications précédentes,
la représentation sémantique (620) comprenant une répartition du poids de poids d'une couche du réseau neuronal.

9. Procédé (200) selon l'une des revendications précédentes,
l'image (610) sur laquelle la représentation sémantique (620) est basée étant créée en utilisant l'électroluminescence, la photoluminescence ou des enregistrements de température.

10. Procédé (200) selon l'une des revendications précédentes, comprenant le fait de
utiliser la représentation sémantique (620) pour comparer la structure de semi-conducteur à une autre structure de semi-conducteur en utilisant une représentation sémantique correspondant à l'autre structure de semi-conducteur pour déterminer des informations des structures de semi-conducteur et/ou un processus de semi-conducteur pour traiter les structures de semi-conducteur.

11. Procédé (200) selon l'une des revendications précédentes, comprenant en outre le fait de traiter la structure de semi-conducteur dans un processus de semi-conducteur ;
générer une autre image comprenant la structure de semi-conducteur après le processus de semi-conducteur ;
utiliser l'autre image pour générer la représentation sémantique (620), en plus d'utiliser l'image (610) ; et
déterminer des paramètres du processus de semi-conducteur en utilisant la représentation sémantique (620).

12. Procédé (300) pour améliorer un processus de semi-conducteur, le procédé comprenant le fait de :
utiliser (310) des structures de semi-conducteur de cellules solaires respectives ;
traiter (320) les structures de semi-conducteur dans un processus de semi-conducteur avec des paramètres de processus prédéterminés ;
générer (330) des représentations sémantiques (620) respectives d'images (610) associées aux structures de semi-conducteur comprenant la structure de semi-conducteur respective, les représentations sémantiques (620) étant générées selon l'une des revendications 1 ou 2 ;
utiliser (340) les représentations sémantiques (620) en association avec les paramètres de processus prédéterminés pour déterminer des phénomènes de processus ; et
ajuster (350) les paramètres de processus en utilisant les phénomènes de processus déterminés précédemment.

13. Procédé (300) selon la revendication 12, comprenant en outre le fait de :
émettre une information d'erreur de processus dans le cas où une déviation d'une propriété de la cellule solaire par rapport à une propriété standard se produit après un processus de semi-conducteur, bien qu'une représentation sémantique (620) basée sur une image (610) de la structure de semi-conducteur de la cellule solaire générée avant le processus de semi-conducteur corresponde à une représentation standard.

14. Procédé (400) pour évaluer des images de qualité à résolution spatiale (610) de structures de semi-conducteur, le procédé comprenant le fait de :
utiliser (410) une représentation sémantique (620) de l'image de qualité (610) de la structure de semi-conducteur générée selon la revendication 1 ou 2 ;
traiter (420) la représentation sémantique (620) dans un réseau neuronal pour produire une première et une deuxième sortie de signal ;
déterminer (430) au moins un paramètre local en évaluant la première sortie de signal comprenant des informations de régions non ombragées de la structure de semi-conducteur ;
déterminer (440) au moins un paramètre global en évaluant la deuxième sortie de signal comprenant des informations de la structure de semi-conducteur entière ; et
déterminer (450) au moins une caractéristique d'une région ombragée en utilisant l'au moins un paramètre local et l'au moins un paramètre global.

15. Procédé (500) selon l'une des revendications précédentes, le procédé pour prédire au moins une propriété d'une cellule solaire comprenant en outre le fait de :
générer (510) au moins une image (610) d'une structure de semi-conducteur de la cellule solaire au moyen d'un procédé d'imagerie après une ou différentes étapes de processus pendant la fabrication de la cellule solaire, l'image (610) comprenant au moins des informations concernant des défauts actifs de recombinaison de la structure de semi-conducteur, concernant des erreurs de processus lors de la fabrication, concernant des apports de courant de la cellule solaire dans différentes conditions d'excitation ou concernant une résistance série de la cellule solaire ; et
prédire (520) la propriété au moyen d'un réseau neuronal entraîné en utilisant des résultats de mesure de mesures de propriétés contactées pour prédire, au moyen de mesures sans contact, la propriété de la cellule solaire,
la propriété comprenant au moins l'un parmi un rendement de la cellule solaire, un courant de court-circuit de la cellule solaire, une tension à vide de la cellule solaire ou un facteur de remplissage de la cellule solaire.
